(19) Europäisches Patentamt
European Patent Office
Office européen des brevets

(11) **EP 4 175 322 A1**

(12) **EUROPEAN PATENT APPLICATION**
published in accordance with Art. 153(4) EPC

(43) Date of publication:
03.05.2023 Bulletin 2023/18

(21) Application number: 21829976.6

(22) Date of filing: 25.05.2021

(51) International Patent Classification (IPC):
H04R 17/00 (2006.01)     H01L 41/047 (2006.01)
H01L 41/09 (2006.01)     H01L 41/193 (2006.01)

(52) Cooperative Patent Classification (CPC):
H04R 17/00; H10N 30/20; H10N 30/857;
H10N 30/87

(86) International application number:
PCT/JP2021/019822

(87) International publication number:
WO 2021/261154 (30.12.2021 Gazette 2021/52)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 25.06.2020 JP 2020109721

(71) Applicant: FUJIFILM Corporation
Tokyo 106-8620 (JP)

(72) Inventor: KAGAWA, Yusuke
Minamiashigara-shi, Kanagawa 250-0193 (JP)

(74) Representative: Klunker IP
Patentanwälte PartG mbB
Destouchesstraße 68
80796 München (DE)

(54) **PIEZOELECTRIC ELEMENT**

(57) An object of the present invention is to provide a piezoelectric element formed of a piezoelectric film including an electrode layer provided on each of both surfaces of a piezoelectric layer and a protective layer provided on the surface of the electrode layer, in which the electrode layer and a conductive member such as a lead wire can be connected to each other with high productivity and the resistance of the connection is also low. The object thereof is achieved by opening through-holes in the protective layer of the piezoelectric film and the conductive member, allowing both through-holes to at least partially overlap each other, filling the through-hole of the protective layer with a conductive filling member, and allowing the filling member to reach the through-hole of the conductive member.

FIG. 1

EP 4 175 322 A1

**Description**

**BACKGROUND OF THE INVENTION**

1. Field of the Invention

The present invention relates to a piezoelectric element used for an electroacoustic transducer or the like.

2. Description of the Related Art

Flexible displays, such as organic EL displays, which are formed of flexible substrates such as plastics have been developed.

In a case where such a flexible display is used as an image display device also serving as a sound generator that reproduces a sound together with an image, such as a television receiver, a speaker which is an acoustic device for generating a sound is required.

Here, examples of typical shapes of speakers of the related art include a funnel-like so-called cone shape and a spherical dome shape. However, in a case where such a speaker is intended to be incorporated in the above-described flexible display, there is a concern that the lightness and the flexibility, which are advantages of the flexible display, are impaired. Further, in a case where the speaker is attached externally, since the speaker is troublesome to carry and difficult to install on a curved wall, there is a concern that a beautiful appearance is impaired.

Meanwhile, a piezoelectric film (electroacoustic conversion film) described in JP2015-29270A is known as a piezoelectric element that can be used as a speaker capable of being integrated with a flexible display without impairing lightness and flexibility.

This piezoelectric film is a piezoelectric film including a piezoelectric layer (polymer-based piezoelectric composite material) obtained by dispersing piezoelectric particles in a viscoelastic matrix consisting of a polymer material having a viscoelasticity at room temperature, an electrode layer (thin film electrode) formed on each of both surfaces of the piezoelectric layer, and a protective layer formed on the surface of the electrode layer, in which a maximal value at which a loss tangent at a frequency of 1 Hz acquired by dynamic viscoelasticity measurement is 0.1 or greater is present in a temperature range of 0°C to 50°C.

**SUMMARY OF THE INVENTION**

The piezoelectric film described in JP2015-29270A has excellent piezoelectric characteristics. Further, since the piezoelectric layer of the piezoelectric film is obtained by dispersing the piezoelectric particles in a polymer material, the piezoelectric film formed of this piezoelectric layer has satisfactory flexibility.

Therefore, according to this piezoelectric film, for example, an electroacoustic conversion film or the like which can be used for a flexible speaker or the like, has flexibility, and has satisfactory piezoelectric characteristics can be realized.

In order to drive such a piezoelectric film including an electrode layer on each of both surfaces of the piezoelectric layer and a protective layer on the surface of the electrode layer, the electrode layer and an external device such as a power supply device for driving are required to be connected to each other with a lead wire.

Various methods can be considered as a method of connecting the lead wire to the electrode layer of the piezoelectric film. However, it is preferable that the resistance of the connection between the electrode layer and the lead wire is low and that the electrode layer and the lead wire can be connected to each other with high productivity even in a case where any method is used.

An object of the present invention is to solve such a problem of the related art and to provide a piezoelectric element formed of a piezoelectric film including an electrode layer provided on each of both surfaces of a piezoelectric layer and a protective layer provided on the surface of the electrode layer, in which the electrode layer and the lead wire or the like can be connected to each other with high productivity and the resistance of the connection between the electrode layer and the lead wire is also low.

In order to solve the above-described problem, the present invention has the following configurations.

[1] A piezoelectric element comprising: a piezoelectric film including a piezoelectric layer, electrode layers which are provided on both surfaces of the piezoelectric layer, and a protective layer which is provided on a surface of the electrode layer on a side opposite to the piezoelectric layer and in which one or more through-holes are provided; a conductive filling member with which the through-holes of the protective layer of the piezoelectric film are filled; and a conductive member which is provided in contact with the protective layer of the piezoelectric film, in which the conductive member has one or more through-holes, the through-holes of the conductive member at least partially overlap the through-holes of the protective layer of the piezoelectric film in a plane direction of the piezoelectric film, and at least a part of the filling member is in contact with an inner wall surface.

[2] The piezoelectric element according to [1], in which a surface roughness Ra of a contact surface between the conductive member and the protective layer of the piezoelectric film is 0.8 $\mu$m or greater.

[3] The piezoelectric element according to [1] or [2], in which a plurality of layers of the piezoelectric film are laminated.

[4] The piezoelectric element according to [3], in which the plurality of layers of the piezoelectric film are laminated by folding the piezoelectric film one or more times.

[5] The piezoelectric element according to any one of [1] to [4], in which at least one through-hole of the conductive member is filled with the filling member.

[6] The piezoelectric element according to any one of [1] to [5], in which the filling member comes into contact with at least one main surface of the conductive member.

[7] The piezoelectric element according to any one of [1] to [6], in which at least one through-hole of the protective layer of the piezoelectric film includes at least one through-hole of the conductive member in the plane direction of the piezoelectric film.

[8] The piezoelectric element according to any one of [1] to [7], in which at least one through-hole of the conductive member includes at least one through-hole of the protective layer of the piezoelectric film in the plane direction of the piezoelectric film.

[9] The piezoelectric element according to any one of [1] to [8], in which at least one through-hole of the protective layer of the piezoelectric film coincides with at least one through-hole of the conductive member in the plane direction of the piezoelectric film.

[10] The piezoelectric element according to any one of [1] to [9], further comprising: a protective member which covers the through-holes of the conductive member.

[11] The piezoelectric element according to any one of [1] to [10], in which the piezoelectric layer is a polymer-based piezoelectric composite material that contains piezoelectric particles in a matrix containing a polymer material.

According to the present invention, it is possible to provide a piezoelectric element formed of a piezoelectric film including an electrode layer provided on each of both surfaces of a piezoelectric layer and a protective layer provided on the surface of the electrode layer, in which the electrode layer and the lead wire or the like can be connected to each other with high productivity and the resistance of the connection between the electrode layer and the lead wire is also low.

**BRIEF DESCRIPTION OF THE DRAWINGS**

Fig. 1 is a view conceptually illustrating an example of a piezoelectric element of the present invention.
Fig. 2 is a schematic plan view illustrating the piezoelectric element illustrated in Fig. 1.
Fig. 3 is a partially enlarged view conceptually illustrating another example of the piezoelectric element of the present invention.
Fig. 4 is a partially enlarged view conceptually illustrating still another example of the piezoelectric element of the present invention.
Fig. 5 is a partially enlarged view conceptually illustrating even still another example of the piezoelectric element of the present invention.
Fig. 6 is a partially enlarged view conceptually illustrating even still another example of the piezoelectric element of the present invention.
Fig. 7 is a partially enlarged view conceptually illustrating even still another example of the piezoelectric element of the present invention.
Fig. 8 is a partially enlarged view conceptually illustrating even still another example of the piezoelectric element of the present invention.
Fig. 9 is a partially enlarged view conceptually illustrating even still another example of the piezoelectric element of the present invention.
Fig. 10 is a conceptual view for describing a method of preparing the piezoelectric element illustrated in Fig. 1.
Fig. 11 is a conceptual view for describing the method of preparing the piezoelectric element illustrated in Fig. 1.
Fig. 12 is a conceptual view for describing the method of preparing the piezoelectric element illustrated in Fig. 1.
Fig. 13 is a conceptual view for describing the method of preparing the piezoelectric element illustrated in Fig. 1.
Fig. 14 is a conceptual view for describing the method of preparing the piezoelectric element illustrated in Fig. 1.
Fig. 15 is a conceptual view for describing the method of preparing the piezoelectric element illustrated in Fig. 1.
Fig. 16 is a conceptual view for describing the method of preparing the piezoelectric element illustrated in Fig. 1.
Fig. 17 is a view conceptually illustrating even still another example of the piezoelectric element of the present invention.

Fig. 18 is a view conceptually illustrating an example of a speaker formed of the piezoelectric element illustrated in Fig. 17.

Fig. 19 is a conceptual view for describing a method of measuring an electric resistance in an example.

## DESCRIPTION OF THE PREFERRED EMBODIMENTS

Hereinafter, a piezoelectric element according to the embodiment of the present invention will be described in detail based on suitable examples illustrated in the accompanying drawings.

Descriptions of the configuration requirements described below may be made based on representative embodiments of the present invention, but the present invention is not limited to such embodiments.

In the present specification, a numerical range shown using "to" indicates a range including numerical values described before and after "to" as a lower limit value and an upper limit value.

In addition, the views shown below are conceptual views for describing the present invention, and the thickness of each layer, the size of the through-hole, the positional relationship of each member (site), and the size of each member are different from the actual ones.

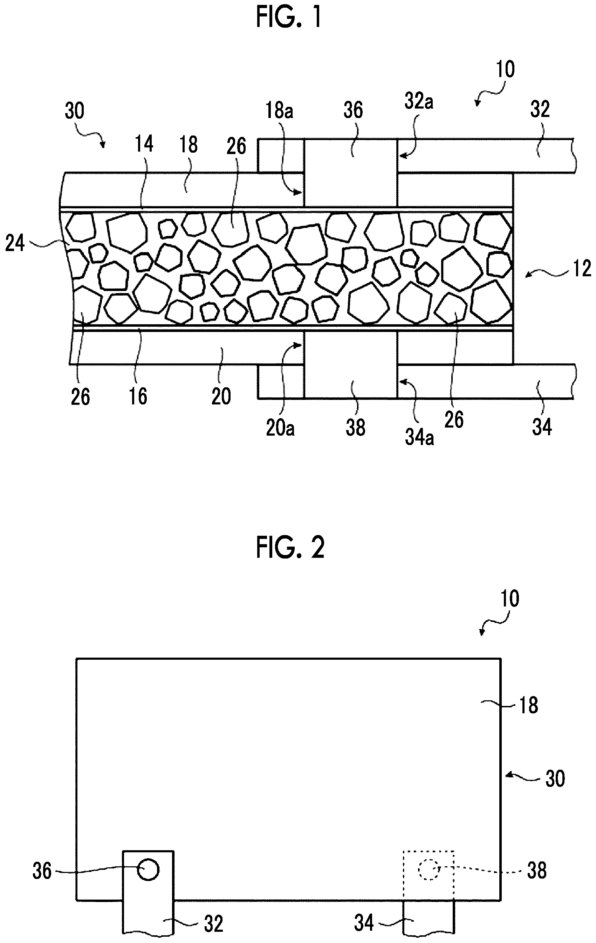

Fig. 1 and Fig. 2 conceptually illustrate an example of a piezoelectric element according to the embodiment of the present invention.

Fig. 1 is a view conceptually illustrating a cross section of the piezoelectric element cut in the thickness direction, and Fig. 2 is a plan view of the piezoelectric element illustrated in Fig. 1. Further, the thickness direction of the piezoelectric element (piezoelectric film) is a lamination direction of a piezoelectric layer, an electrode layer, and a protective layer in the piezoelectric film described below. In addition, the plan view is a view illustrating the piezoelectric element according to the embodiment of the present invention as viewed in the thickness direction.

As illustrated in Fig. 1, a piezoelectric element 10 includes a piezoelectric film 30, a first lead wire 32, a second lead wire 34, a first filling member 36, and a second filling member 38. The first lead wire 32 and the second lead wire 34 are conductive members in the present invention.

Further, the piezoelectric film 30 includes a piezoelectric layer 12, a first electrode layer 14 laminated on one surface of the piezoelectric layer 12, a first protective layer 18 laminated on the surface of the first electrode layer 14, a second electrode layer 16 laminated on the other surface of the piezoelectric layer 12, and a second protective layer 20 laminated on the surface of the second electrode layer 16.

The first lead wire 32 is provided by being laminated on the first protective layer 18 of the piezoelectric film 30.

A through-hole 18a is formed in the first protective layer 18, and a through-hole 32a is formed in the first lead wire 32. The through-hole 18a and the through-hole 32a have a cylindrical shape with an identical diameter, and the centers thereof coincide with each other in the plane direction. The first filling member 36 fills both through-holes such that the through-hole 18a and the through-hole 32a are filled with the first filling member 36, that is, buried with the first filling member 36.

The second lead wire 34 is provided by being laminated on the second protective layer 20 of the piezoelectric film 30.

A through-hole 20a is formed in the second protective layer 20, and a through-hole 34a is formed in the second lead wire 34. The through-hole 20a and the through-hole 34a have a cylindrical shape with an identical diameter, and the centers thereof coincide with each other in the plane direction. The second filling member 38 fills both through-holes such that the through-hole 20a and the through-hole 34a are filled with the second filling member 38, that is, buried with the second filling member 38.

In the present invention, the plane direction is the plane direction of the main surface of the piezoelectric film 30. The main surface is the maximum surface of a sheet-like material (a film, a plate-like material, or a layer) and corresponds to both surfaces in the thickness direction.

In the piezoelectric element 10 according to the embodiment of the present invention, the piezoelectric layer 12 of the piezoelectric film 30 contains the piezoelectric particles 26, which are piezoelectric particles, in a matrix 24 containing a polymer material. That is, the piezoelectric layer 12 is a polymer-based piezoelectric composite material.

Here, the polymer-based piezoelectric composite material (piezoelectric layer 12) is used, for example, in an electroacoustic conversion film. It is preferable that the polymer-based piezoelectric composite material used in the electroacoustic conversion film satisfies the following requirements. Further, in the present invention, room temperature is in a range of 0°C to 50°C.

(i) Flexibility

For example, in a case of being gripped in a state of being loosely bent like a document such as a newspaper or a magazine as a portable device, the piezoelectric film is continuously subjected to large bending deformation from the outside at a relatively slow vibration of less than or equal to a few Hz. In this case, in a case where the polymer-based piezoelectric composite material is hard, a large bending stress is generated to that extent, and a crack is generated at the interface between a polymer matrix and piezoelectric particles, which may lead to breakage. Accordingly, the polymer-based piezoelectric composite material is required to have suitable flexibility. In addition, in a case where strain energy is diffused into the outside as heat, the stress is able to be relieved. Therefore, the polymer-based piezoelectric composite material is required to have a suitably large loss tangent.

(ii) Acoustic quality

In a speaker, the piezoelectric particles vibrate at a frequency of an audio band of 20 Hz to 20 kHz, and the vibration energy causes the entire vibration plate (polymer-based piezoelectric composite material) to vibrate integrally so that a sound is reproduced. Therefore, in order to increase the transmission efficiency of the vibration energy, the polymer-based piezoelectric composite material is required to have appropriate hardness. In addition, in a case where the frequencies of the speaker are smooth as the frequency characteristic thereof, an amount of change in acoustic quality in a case where the lowest resonance frequency $f_0$ is changed in association with a change in the curvature of the speaker decreases. Therefore, the polymer-based piezoelectric composite material is required to have a suitably large loss tangent.

It is known that the lowest resonance frequency $f_0$ of the vibration plate for a speaker is represented by the following equation. Here, s represents the stiffness of the vibration system and m represents the mass.

Lowest resonance frequency :

$$f_0 = \frac{1}{2\pi} \sqrt{\frac{s}{m}}$$

Here, as the degree of curvature of the piezoelectric film, that is, the radius of curvature of the curved portion increases, the mechanical stiffness s decreases, and thus the lowest resonance frequency $f_0$ decreases. That is, the acoustic quality (the volume and the frequency characteristics) of the speaker changes depending on the radius of curvature of the piezoelectric film.

That is, the flexible polymer-based piezoelectric composite material used as an electroacoustic conversion film is required to exhibit a behavior of being rigid with respect to a vibration of 20 Hz to 20 kHz and being flexible with respect to a vibration of less than or equal to a few Hz. In addition, the loss tangent of a polymer-based piezoelectric composite material is required to be suitably large with respect to the vibration of all frequencies of 20 kHz or less.

In general, a polymer solid has a viscoelasticity relieving mechanism, and a molecular movement having a large scale is observed as a decrease (relief) in a storage elastic modulus (Young's modulus) or a maximal value (absorption) in a loss elastic modulus along with an increase in temperature or a decrease in frequency. Among these, the relief due to a microbrown movement of a molecular chain in an amorphous region is referred to as main dispersion, and an extremely large relieving phenomenon is observed. A temperature at which this main dispersion occurs is a glass transition point (Tg), and the viscoelasticity relieving mechanism is most remarkably observed.

The polymer-based piezoelectric composite material exhibiting a behavior of being rigid with respect to a vibration of 20 Hz to 20 kHz and being flexible with respect to a vibration of less than or equal to a few Hz is realized by using a polymer material whose glass transition point is room temperature as a matrix of the polymer-based piezoelectric composite material (piezoelectric layer 12). In particular, from the viewpoint that such a behavior is suitably exhibited, it is preferable that a polymer material in which the glass transition point at a frequency of 1 Hz is at room temperature, that is, in a range of 0°C to 50°C is used for a matrix of the polymer-based piezoelectric composite material. Further, the polymer material having a glass transition point at room temperature is, that is, a polymer material having a viscoelasticity at room temperature.

As the polymer material having a viscoelasticity at room temperature, various known materials can be used. It is preferable that a polymer material in which the maximal value of a loss tangent Tanδ at a frequency of 1 Hz according to a dynamic viscoelasticity test at room temperature, that is, in a range of 0°C to 50° is 0.5 or greater is used as the polymer material.

In this manner, in a case where the polymer-based piezoelectric composite material is slowly bent due to an external force, stress concentration on the interface between the polymer matrix and the piezoelectric particles at the maximum bending moment portion is relieved, and thus high flexibility can be expected.

In the polymer material having a viscoelasticity at room temperature, it is preferable that a storage elastic modulus (E') at a frequency of 1 Hz according to the dynamic viscoelasticity measurement is 100 MPa or greater at 0°C and 10 MPa or less at 50°C.

In this manner, the bending moment generated in a case where the polymer-based piezoelectric composite material is slowly bent due to the external force can be reduced, and the polymer-based piezoelectric composite material can exhibit a behavior of being rigid with respect to an acoustic vibration of 20 Hz to 20 kHz.

In addition, it is more suitable that the relative dielectric constant of the polymer material having a viscoelasticity at room temperature is 10 or greater at 25°C. Accordingly, in a case where a voltage is applied to the polymer-based piezoelectric composite material, a higher electric field is applied to the piezoelectric particles in the polymer matrix, and thus a large deformation amount can be expected.

However, in consideration of ensuring satisfactory moisture resistance and the like, it is suitable that the relative dielectric constant of the polymer material is 10 or less at 25°C.

Examples of the polymer material having a viscoelasticity at room temperature and satisfying such conditions include cyanoethylated polyvinyl alcohol (cyanoethylated PVA), polyvinyl acetate, polyvinylidene chloride-co-acrylonitrile, a polystyrene-vinyl polyisoprene block copolymer, polyvinyl methyl ketone, and polybutyl methacrylate. In addition, as these polymer materials, a commercially available product such as Hybrar 5127 (manufactured by Kuraray Co., Ltd.) can also be suitably used. Among these, it is preferable to use a material containing a cyanoethyl group and particularly preferable to use cyanoethylated PVA as the polymer material.

Further, these polymer materials in the matrix 24 may be used alone or in combination (mixture) of two or more kinds thereof.

In the matrix 24 formed of such a polymer material having a viscoelasticity at room temperature, a plurality of polymer materials may be used in combination as necessary.

That is, for the purpose of adjusting dielectric characteristics, mechanical characteristics, and the like, other dielectric polymer materials may be added to the matrix 24 in addition to the polymer material having a viscoelasticity at room temperature, such as cyanoethylated PVA, as necessary.

Examples of the dielectric polymer material that can be added thereto include a fluorine-based polymer such as polyvinylidene fluoride, a vinylidene fluoride-tetrafluoroethylene copolymer, a vinylidene fluoride-trifluoroethylene copolymer, a polyvinylidene fluoride-trifluoroethylene copolymer, or a polyvinylidene fluoride-tetrafluoroethylene copolymer, a polymer containing a cyano group or a cyanoethyl group such as a vinylidene cyanide-vinyl acetate copolymer, cyanoethyl cellulose, cyanoethyl hydroxysaccharose, cyanoethyl hydroxycellulose, cyanoethyl hydroxypullulan, cyanoethyl methacrylate, cyanoethyl acrylate, cyanoethyl hydroxyethyl cellulose, cyanoethyl amylose, cyanoethyl hydroxypropyl cellulose, cyanoethyl dihydroxypropyl cellulose, cyanoethyl hydroxypropyl amylose, cyanoethyl polyacrylamide, cyanoethyl polyacrylate, cyanoethyl pullulan, cyanoethyl polyhydroxymethylene, cyanoethyl glycidol pullulan, cyanoethyl saccharose, or cyanoethyl sorbitol, and synthetic rubber such as nitrile rubber or chloroprene rubber.

Among these, a polymer material containing a cyanoethyl group is suitably used.

Further, the number of kinds of the dielectric polymers to be added to the matrix 24 of the piezoelectric layer 12 in addition to the material having a viscoelasticity at room temperature, such as cyanoethylated PVA, is not limited to one, and a plurality of kinds of the materials may be added.

In addition, for the purpose of adjusting the glass transition point Tg, a thermoplastic resin such as a vinyl chloride resin, polyethylene, polystyrene, a methacrylic resin, polybutene, or isobutylene, and a thermosetting resin such as a phenol resin, a urea resin, a melamine resin, an alkyd resin, or mica may be added to the matrix 24 in addition to the dielectric polymer materials.

Further, for the purpose of improving the pressure sensitive adhesiveness, a viscosity imparting agent such as rosin ester, rosin, terpene, terpene phenol, or a petroleum resin may be added.

The addition amount of materials to be added to the matrix 24 of the piezoelectric layer 12 other than the polymer material having a viscoelasticity at room temperature such as cyanoethylated PVA is not particularly limited, but is preferably set to 30% by mass or less in terms of the proportion of the materials in the matrix 24.

In this manner, the characteristics of the polymer material to be added can be exhibited without impairing the viscoelasticity relieving mechanism in the matrix 24, and thus preferable results, for example, an increase in the dielectric constant, improvement of the heat resistance, and improvement of the adhesiveness between the piezoelectric particles 26 and the electrode layer can be obtained.

In the piezoelectric element 10 of the present invention, the piezoelectric layer 12 contains the piezoelectric particles 26 in such a matrix 24.

Known particles can be used as the piezoelectric particles 26, but it is preferable that the piezoelectric particles 26 consist of ceramic particles having a perovskite type or wurtzite type crystal structure.

Examples of the ceramics particles forming the piezoelectric particles 26 include lead zirconate titanate (PZT), lead lanthanum zirconate titanate (PLZT), barium titanate ($BaTiO_3$), zinc oxide (ZnO), and a solid solution (BFBT) of barium titanate and bismuth ferrite ($BiFe_3$).

The particle diameter of such piezoelectric particles 26 is not limited, and may be appropriately selected depending on the size of the piezoelectric layer 12 (piezoelectric film 30), the applications of the piezoelectric element 10, and the like. The particle diameter of the piezoelectric particles 26 is preferably in a range of 1 to 10 μm.

By setting the particle diameter of the piezoelectric particles 26 to be in the above-described range, preferable results in terms of achieving both excellent piezoelectric characteristics and flexibility of the piezoelectric film 30 can be obtained.

In Fig. 1, the piezoelectric particles 26 in the piezoelectric layer 12 are irregularly dispersed in the matrix 24, but the present invention is not limited thereto.

That is, the piezoelectric particles 26 in the piezoelectric layer 12 may be irregularly or regularly dispersed in the matrix 24 as long as the piezoelectric particles 26 are preferably uniformly dispersed therein.

Further, the particle diameter of the piezoelectric particles 26 may or may not be uniform.

In the piezoelectric film 30, the ratio between the amount of the matrix 24 and the amount of the piezoelectric particles 26 in the piezoelectric layer 12 is not limited and may be appropriately set according to the size and the thickness of the piezoelectric film 30 in the plane direction, the applications of the piezoelectric element 10, the characteristics required for the piezoelectric film 30, and the like.

The volume fraction of the piezoelectric particles 26 in the piezoelectric layer 12 is preferably in a range of 30% to 80% and more preferably 50% or greater. Therefore, it is more preferable that the volume fraction of the piezoelectric particles 26 in the piezoelectric layer 12 is set to be in a range of 50% to 80%.

By setting the ratio between the amount of the matrix 24 and the amount of the piezoelectric particles 26 to be in the above-described ranges, preferable results in terms of achieving both of excellent piezoelectric characteristics and flexibility can be obtained.

In the piezoelectric element 10, the thickness of the piezoelectric layer 12 is not particularly limited and may be appropriately set according to the applications of the piezoelectric element 10, the characteristics required for the piezoelectric element 10, and the like.

It is advantageous that the thickness of the piezoelectric layer 12 increases in terms of the rigidity such as the strength of stiffness of a so-called sheet-like material, but the voltage (potential difference) required to stretch and contract the piezoelectric element 10 by the same amount increases.

The thickness of the piezoelectric layer 12 is preferably in a range of 8 to 300 μm, more preferably in a range of 8 to 200 μm, still more preferably in a range of 10 to 150 μm, and particularly preferably in a range of 15 to 100 μm.

By setting the thickness of the piezoelectric layer 12 to be in the above-described ranges, preferable results in terms of achieving both ensuring of the rigidity and moderate elasticity can be obtained.

It is preferable that the piezoelectric layer 12 is subjected to a polarization treatment (poling) in the thickness direction. The polarization treatment will be described in detail later.

In the piezoelectric element according to the embodiment of the present invention, the piezoelectric layer 12 is not limited to the polymer-based piezoelectric composite material as illustrated in the figure, and a known piezoelectric material can be used.

Examples of the piezoelectric material that can be used for the piezoelectric element according to the embodiment of the present invention include polyvinylidene fluoride, a fluorine resin other than polyvinylidene fluoride, and a laminated film of a film consisting of poly-L lactic acid and a film consisting of poly-D lactic acid.

However, from the viewpoints of obtaining excellent acoustic characteristics, excellent flexibility, and the like, a polymer-based piezoelectric composite material obtained by dispersing the piezoelectric particle 26 in the matrix 24 containing a polymer material is suitably used as the piezoelectric layer 12.

As illustrated in Fig. 1, the piezoelectric film 30 of the piezoelectric element 10 in the illustrated example has the first electrode layer 14 on one surface of such a piezoelectric layer 12 and has the first protective layer 18 on the surface thereof. Further, the piezoelectric film 30 has a configuration in which the second electrode layer 16 is provided on a surface of the piezoelectric layer 12 on a side opposite to the first electrode layer 14 and the second protective layer 20 is provided on the surface thereof. In other words, the first protective layer 18 is provided on a surface of the first electrode layer 14 on a side opposite to the piezoelectric layer 12. Further, the second protective layer 20 is provided on a surface of the second electrode layer 16 on a side opposite to the piezoelectric layer 12.

In the piezoelectric film 30, the first electrode layer 14 and the second electrode layer 16 form an electrode pair. That is, the piezoelectric film 30 has a configuration in which both surfaces of the piezoelectric layer 12 are sandwiched between a pair of electrodes, that is, the first electrode layer 14 and the second electrode layer 16 and this laminate is sandwiched between the first protective layer 18 and the second protective layer 20.

In such a piezoelectric film 30, the region sandwiched between the first electrode layer 14 and the second electrode layer 16 stretches and contracts according to the applied voltage.

In the present invention, the terms "first" and "second" in the first electrode layer 14 and the first protective layer 18, and the second electrode layer 16 and the second protective layer 20 are provided to describe the piezoelectric element 10 for convenience. Therefore, the terms "first" and "second" in each member of the piezoelectric element 10 have no technical meaning and are irrelevant to the actual use state such as a position in the vertical direction.

The same applies to the lead wire and the filling member described below.

The first protective layer 18 and the second protective layer 20 in the piezoelectric film 30 (piezoelectric element 10) have a function of covering the first electrode layer 14 and the second electrode layer 16 and applying moderate rigidity and mechanical strength to the piezoelectric layer 12. That is, the piezoelectric layer 12 consisting of the matrix 24 and the piezoelectric particles 26 in the piezoelectric film 30 exhibits extremely excellent flexibility under bending deformation at a slow vibration, but may have insufficient rigidity or mechanical strength depending on the applications. As a compensation for this, the piezoelectric element 10 is provided with the first protective layer 18 and the second protective layer 20.

The first protective layer 18 and the second protective layer 20 are not limited, and various sheet-like materials can be used, and suitable examples thereof include various resin films.

Among these, from the viewpoints of excellent mechanical characteristics and heat resistance, a resin film consisting of polyethylene terephthalate (PET), polypropylene (PP), polystyrene (PS), polycarbonate (PC), polyphenylene sulfite (PPS), polymethyl methacrylate (PMMA), polyetherimide (PEI), polyimide (PI), polyethylene naphthalate (PEN), triacetyl cellulose (TAC), and a cyclic olefin-based resin is suitably used.

The thickness of the first protective layer 18 and the second protective layer 20 is not limited. In addition, the thicknesses of the first protective layer 18 and the second protective layer 20 are basically the same as each other, but may be different from each other.

Here, in a case where the rigidity of the first protective layer 18 and the second protective layer 20 is extremely high, not only is the stretch and contraction of the piezoelectric layer 12 constrained, but also the flexibility is impaired. Therefore, it is advantageous that the thickness of the first protective layer 18 and the thickness of the second protective layer 20 decrease except for the case where the mechanical strength or satisfactory handleability as a sheet-like material is required.

In a case where the thickness of the first protective layer 18 and the second protective layer 20 in the piezoelectric element 10 is two times or less the thickness of the piezoelectric layer 12, preferable results in terms of achieving both ensuring of the rigidity and moderate elasticity can be obtained.

For example, in a case where the thickness of the piezoelectric layer 12 is 50 $\mu$m and the first protective layer 18 and the second protective layer 20 consist of PET, the thickness of the first protective layer 18 and the second protective layer 20 is preferably 100 $\mu$m or less, more preferably 50 $\mu$m or less, and still more preferably 25 $\mu$m or less.

In the piezoelectric film 30 of the piezoelectric element 10, the first electrode layer 14 is formed between the piezoelectric layer 12 and the first protective layer 18, and the second electrode layer 16 is formed between the piezoelectric layer 12 and the second protective layer 20.

The first electrode layer 14 and the second electrode layer 16 are provided to apply a voltage to the piezoelectric layer 12.

In the present invention, the material for forming the first electrode layer 14 and the second electrode layer 16 is not limited, and various conductors can be used as the material. Specific examples thereof include metals such as carbon, palladium, iron, tin, aluminum, nickel, platinum, gold, silver, copper, titanium, chromium, and molybdenum, alloys thereof, laminates and composites of these metals and alloys, and indium tin oxide. Among these, copper, aluminum, gold, silver, platinum, and indium tin oxide are suitable as the first electrode layer 14 and the second electrode layer 16.

In addition, the method of forming the first electrode layer 14 and the second electrode layer 16 is also not limited, and various known methods, for example, a film forming method such as a vapor-phase deposition method (vacuum film forming method) such as vacuum vapor deposition or sputtering, a film forming method using plating, and a method of bonding a foil formed of the materials described above can be used.

Among these, particularly from the viewpoint of ensuring the flexibility of the piezoelectric element 10, a thin film made of copper, aluminum, or the like formed by vacuum vapor deposition is suitably used as the first electrode layer 14 and the second electrode layer 16. Among these, particularly a thin film made of copper formed by vacuum vapor deposition is suitably used.

The thicknesses of the first electrode layer 14 and the second electrode layer 16 are not limited. In addition, the thicknesses of the first electrode layer 14 and the second electrode layer 16 are basically the same as each other, but may be different from each other.

Here, similarly to the first protective layer 18 and the second protective layer 20 described above, in a case where the rigidity of the first electrode layer 14 and the second electrode layer 16 is extremely high, not only is the stretch and contraction of the piezoelectric layer 12 constrained, but also the flexibility is impaired. Therefore, it is advantageous that the thicknesses of the first electrode layer 14 and the second electrode layer 16 decrease in a case where the electric resistance is not excessively high.

It is suitable that the product of the thickness and the Young's modulus of the first electrode layer 14 and the second electrode layer 16 of the piezoelectric film 30 (piezoelectric element 10) is less than the product of the thickness and the Young's modulus of the first protective layer 18 and the second protective layer 20 from the viewpoint that the flexibility is not considerably impaired.

As an example, in a case where the first protective layer 18 and the second protective layer 20 are formed of PET and the first electrode layer 14 and the second electrode layer 16 are formed of copper, the Young's modulus of PET is approximately 6.2 GPa, and the Young's modulus of copper is approximately 130 GPa. Therefore, in this case, in a case where the thickness of the first protective layer 18 and the second protective layer 20 is set to 25 μm, the thickness of the first electrode layer 14 and the second electrode layer 16 is preferably 1.2 μm or less, more preferably 0.3 μm or less, and still more preferably 0.1 μm or less.

As described above, the piezoelectric film 30 has a configuration in which the piezoelectric layer 12 containing the piezoelectric particles 26 in the matrix 24 containing the polymer material that has a viscoelasticity at room temperature is sandwiched between the first electrode layer 14 and the second electrode layer 16 and this laminate is sandwiched between the first protective layer 18 and the second protective layer 20.

It is preferable that, in such a piezoelectric film 30, the maximal value of the loss tangent (tan δ) at a frequency of 1 Hz according to dynamic viscoelasticity measurement is present at room temperature and more preferable that the maximal value at which the loss tangent is 0.1 or greater is present at room temperature.

In this manner, even in a case where the piezoelectric film 30 is subjected to large bending deformation at a relatively slow vibration of less than or equal to a few Hz from the outside, since the strain energy can be effectively diffused to the outside as heat, occurrence of cracks at the interface between the polymer matrix and the piezoelectric particles can be prevented.

In the piezoelectric film 30, it is preferable that the storage elastic modulus (E') at a frequency of 1 Hz according to the dynamic viscoelasticity measurement is in a range of 10 to 30 GPa at 0°C and in a range of 1 to 10 GPa at 50°C.

In this manner, the piezoelectric film 30 may have large frequency dispersion in the storage elastic modulus (E') at room temperature. That is, the piezoelectric film 30 can exhibit a behavior of being rigid with respect to a vibration of 20 Hz to 20 kHz and being flexible with respect to a vibration of less than or equal to a few Hz.

In the piezoelectric film 30, it is preferable that the product of the thickness and the storage elastic modulus (E') at a frequency of 1 Hz according to the dynamic viscoelasticity measurement is in a range of $1.0 \times 10^6$ to $2.0 \times 10^6$ N/m at 0°C and in a range of $1.0 \times 10^5$ to $1.0 \times 10^6$ N/m at 50°C.

In this manner, the piezoelectric film 30 may have moderate rigidity and mechanical strength within a range not impairing the flexibility and the acoustic characteristics.

Further, in the piezoelectric film 30, it is preferable that the loss tangent (Tan δ) at a frequency of 1 kHz at 25°C is 0.05 or greater in a master curve obtained from the dynamic viscoelasticity measurement.

In this manner, the frequency of a speaker formed of the piezoelectric film 30 is smooth as the frequency characteristic thereof, and thus a change in acoustic quality in a case where the lowest resonance frequency f0 is changed according to a change in the curvature of the speaker can be decreased.

Further, the piezoelectric film 30 constituting the piezoelectric element 10 according to the embodiment of the present invention may include a bonding layer for bonding the electrode layer and the piezoelectric layer 12 to each other and a bonding layer for bonding the electrode layer and the protective layer to each other, in addition to the electrode layers and the protective layers.

The bonding agent may be an adhesive or a pressure sensitive adhesive. Further, the same material as the polymer material obtained by removing the piezoelectric particles 26 from the piezoelectric layer 12, that is, the matrix 24 can also be suitably used as the bonding agent. Further, the bonding layer may be provided on both the first electrode layer 14 side and the second electrode layer 16 side or may be provided only on one of the first electrode layer 14 side or the second electrode layer 16 side.

The piezoelectric element according to the embodiment of the present invention includes a conductive member such as a lead wire for electrically connecting the electrode layer of the piezoelectric film 30 and an external device such as a driving power supply by being brought into contact with the protective layer, in order to drive the piezoelectric film 30. The conductive member is electrically connected to the electrode layer by a conductive filling member with which the through-hole formed in the protective layer of the piezoelectric film 30 is filled.

Here, in the piezoelectric element according to the embodiment of the present invention, the conductive member also has a through-hole. At least a part of the through-hole of the conductive member overlaps the through-hole of the protective layer in the plane direction, and at least a part of the filling material comes into contact with the inner wall surface.

The piezoelectric element 10 in the illustrated example includes a first lead wire 32 laminated on the first protective layer 18 and a second lead wire 34 laminated on the second protective layer 20 as conductive members. In the illustrated example, the first lead wire 32 and the second lead wire 34 have a plate shape as an example.

A through-hole 18a is formed in the first protective layer 18, and a through-hole 32a is formed in the first lead wire 32. The through-hole 18a and the through-hole 32a have a cylindrical shape with an identical diameter, and the centers in the upper surface and the lower surface coincide with each other in the plane direction as a preferable aspect. Further, a through-hole 20a is formed in the second protective layer 20, and a through-hole 34a is formed in the second lead wire 34. The through-hole 20a and the through-hole 34a have a cylindrical shape with an identical diameter, and the centers in the upper surface and the lower surface coincide with each other in the plane direction as a preferable aspect.

The through-hole 18a of the first protective layer 18 is filled with the first filling member 36. At least a part of the first filling member 36 comes into contact with the inner wall surface of the through-hole 32a of the first lead wire 32. In this manner, the first lead wire 32 and the first electrode layer 14 are connected to each other. In the illustrated example, as a preferable aspect, not only the through-hole 18a of the second protective layer 20 but also the through-hole 32a of the first lead wire 32 are filled with the first filling member 36, that is, buried with the first filling member 36.

Further, the through-hole 20a of the second protective layer 20 is filled with the second filling member 38. At least a part of the second filling member 38 comes into contact with the inner wall surface of the through-hole 34a of the second lead wire 34. In this manner, the second lead wire 34 and the second electrode layer 16 are connected to each other. In the illustrated example, as a preferable aspect, not only the through-hole 20a of the second protective layer 20 but also the through-hole 34a of the second lead wire 34 are filled with the second filling member 38, that is, buried with the second filling member 38.

Since the piezoelectric element according to the embodiment of the present invention has the above-described configuration, in the piezoelectric element formed of the above-described piezoelectric film, the resistance of connection between the electrode layer and the conductive member for connection with an external device is reduced, and the productivity of connection between the electrode layer and the conductive member is improved.

As described in JP2015-29270A, a piezoelectric film having electrode layers provided on both surfaces of a piezoelectric layer and protective layers provided to cover the electrode layers is known. In order to drive this piezoelectric film, it is necessary to connect a lead wire or the like for connecting an external device such as a driving power supply to the electrode layer, to the electrode layer.

Various methods can be considered as a method of connecting the electrode layer and the lead wire to each other. Here, since the piezoelectric film has satisfactory flexibility as described above, it is preferable that the connecting portion between the electrode layer and the lead wire also has flexibility.

Examples of the connection method that satisfies the above-described requirement include a connection method of providing a through-hole in the protective layer, filling the through-hole with a conductive filling member such as a conductive paste, and providing a lead wire to cover the through-hole (filling member).

Here, in the piezoelectric element formed of the piezoelectric film, it is required that the resistance of the connection between the electrode layer and the lead wire is low and that the connection between the electrode layer and the lead wire can be performed with high productivity.

However, in a configuration in which a through-hole is provided in the protective layer so that the through-hole is filled with a conductive paste or the like and a lead wire is provided to cover the through-hole, the contact area between the filling member and the lead wire cannot be increased, and the resistance of the connection between the electrode layer and the lead wire cannot be reduced.

Further, as described above, a resin film is suitably used as the protective layer of the piezoelectric film. Therefore, as the conductive paste serving as the filling member, paste cured by volatilization of a solvent is used without using paste cured by heating and sintering. Therefore, in a configuration in which a through-hole is provided in the protective layer so that the through-hole is filled with a conductive paste or the like and a lead wire is provided to cover the through-hole, volatilization of a solvent and curing of the conductive paste take time and thus the productivity is poor.

Meanwhile, in the piezoelectric element according to the embodiment of the present invention, a through-hole is also provided in the lead wire (conductive member) so that the through-hole of the protective layer and the through-hole of the lead wire at least partially overlap each other in the plane direction and at least a part of the conductive paste (filling member) is brought into contact with the inner wall of the through-hole of the lead wire.

As illustrated in Figs. 1 and 2, it is preferable that the through-hole of the protective layer and the through-hole of the lead wire completely overlap each other in the plane direction or one through-hole includes the other through-hole as described below and the through-hole of the lead wire is filled with the conductive paste, that is, completely buried with the conductive paste.

Therefore, according to the piezoelectric element according to the embodiment of the present invention, the contact area between the filling member and the lead wire can be increased as compared with the above-described method, and as a result, the resistance of the connection between the electrode layer and the lead wire can be reduced.

In addition, since the lead wire also has a through-hole and at least a part of the through-hole overlaps the through-hole of the protective layer in the plane direction, the conductive paste with which the through-hole is filled is in a state of being opened to the atmosphere. As a result, the time required for the volatilization of the solvent and curing of the conductive paste can be significantly shortened, and the connection between the electrode layer and the lead wire can be performed with high productivity.

As described above, in the piezoelectric element 10 according to the embodiment of the present invention, the terms "first" and "second" in the electrode layer, the protective layer, the lead wire, and the filling member have no technical meaning.

Further, the structure of the connection between the first electrode layer 14 and the first lead wire 32 and the structure of the connection between the second electrode layer 16 and the second lead wire 34 are basically the same as each other.

Therefore, in the description below, the side of the first electrode layer 14 will be described as a representative example in a case where it is not necessary to distinguish the side of the first electrode layer 14 from the side of the second electrode layer 16.

In the piezoelectric element 10 of the illustrated example, as described above, the through-hole 18a (through-hole 20a) is formed in the first protective layer 18 (second protective layer 20), and the through-hole 32a (through-hole 34a) is formed in the first lead wire 32 (second lead wire 34). Both through-holes partially overlap each other in the plane direction. In the illustrated example, as a preferable aspect, both through-holes have a cylindrical shape with an identical diameter, and the centers thereof coincide with each other in the plane direction.

The through-hole 18a is filled with the first filling member 36 (second filling member 38). Since at least a part of the first filling member 36 comes into contact with the inner wall surface of the through-hole 32a of the first lead wire 32, the first lead wire 32 and the first electrode layer 14 are connected to each other. In the illustrated example, as a preferable aspect, not only the through-hole 18a of the first protective layer 18 but also the through-hole 32a of the first lead wire 32 are filled with the first filling member 36, that is, buried with the first filling member 36.

Therefore, in the piezoelectric element 10, the conductive paste which is the first filling member 36 (second filling member) with which the through-hole 18a of the first protective layer 18 is filled is opened to the atmosphere by the through-hole 32a of the first lead wire 32. As a result, the time required for the volatilization of the solvent and curing of the conductive paste can be significantly shortened, and the connection between the electrode layer and the lead wire can be performed with high productivity. In particular, as in the illustrated example, curing of the conductive paste can be further promoted and the productivity can be improved by allowing the through-hole 18a and the through-hole 32a to coincide with each other in the plane direction.

In addition, since the first filling member 36 comes into contact with the through-hole 32a of the first lead wire 32 and the through-hole 32a is preferably filled with the first filling member 36, the contact area between the first filling member 36 and the first lead wire 32 can also be sufficiently ensured and the resistance of the connection between the first electrode layer 14 and the first lead wire can also be reduced.

In the piezoelectric element 10 of the illustrated example, the through-hole 18a of the first protective layer 18 and the through-hole 32a of the first lead wire 32 have a cylindrical shape with an identical diameter, and the centers thereof coincide with each other in the plane direction. That is, the through-hole 18a and the through-hole 32a completely overlap (coincide) in the plane direction.

However, the piezoelectric element 10 according to the embodiment of the present invention is not limited thereto, and various configurations can be used.

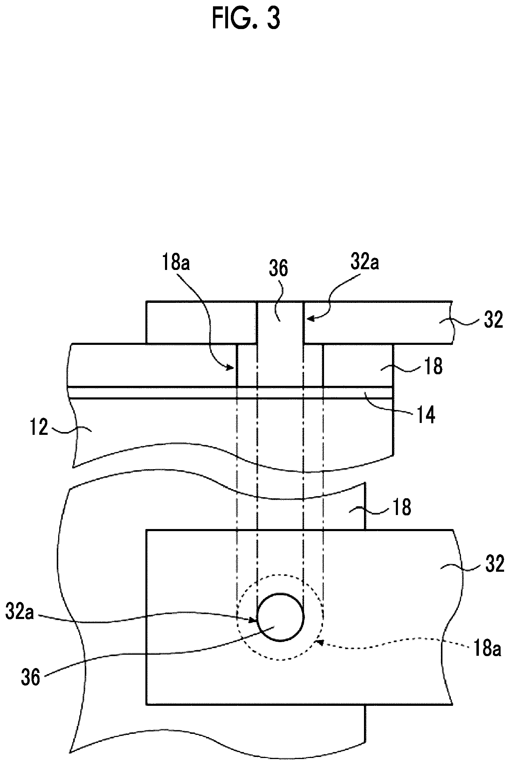

As conceptually illustrated in Fig. 3, a configuration in which the through-hole 18a of the first protective layer 18 and the through-hole 32a of the first lead wire 32 have a cylindrical shape and the diameter of the through-hole 18a is greater than the diameter of the through-hole 32a is shown as an example.

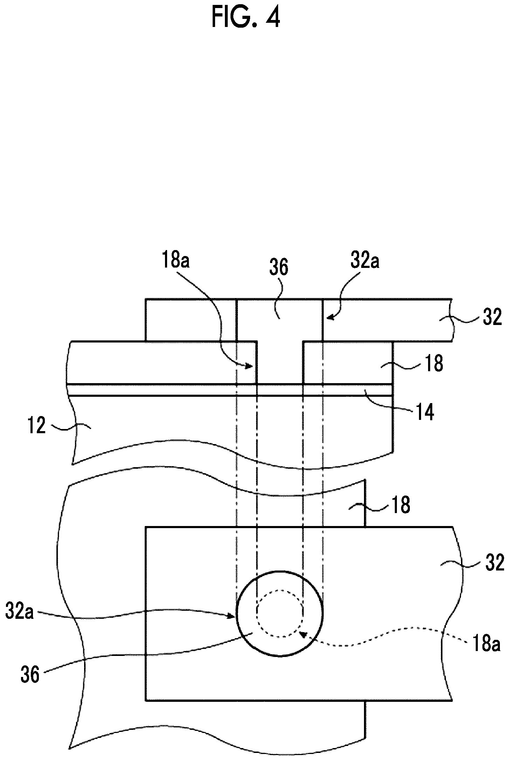

On the contrary, as conceptually illustrated in Fig. 4, a configuration in which the through-hole 32a of the first lead wire 32 and the through-hole 18a of the first protective layer 18 have a cylindrical shape and the diameter of the through-hole 32a is greater than the diameter of the through-hole 18a is shown as another example.

In the examples illustrated in Figs. 3 and 4, the center of the through-hole 18a of the first protective layer 18 and the center of the through-hole 32a of the first lead wire 32 coincide with each other. However, the configuration in which any one of the through-hole 18a or the through-hole 32a includes the other in the plane direction is not limited thereto, and the centers of the through-hole 18a and the through-hole 32a may be different from each other as long as one through-hole includes the other.

Further, in the example described above, the through-hole 18a of the first protective layer 18 and the through-hole 32a of the first lead wire 32 coincide with each other in the plane direction, or one through-hole includes the other through-hole in the plane direction, but the present invention is not limited thereto.

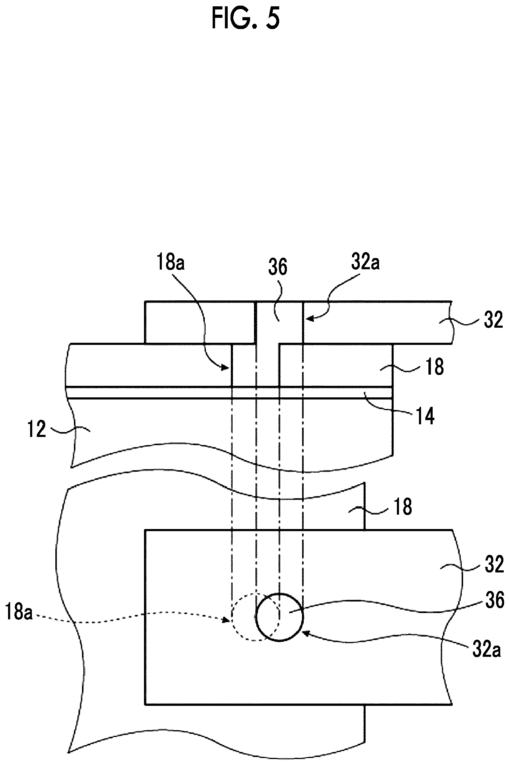

In the piezoelectric element according to the embodiment of the present invention, the through-hole 18a and the through-hole 32a may be displaced from each other in the plane direction as conceptually illustrated in Fig. 5, regardless of whether the diameters of the through-hole 18a and the through-hole 32a are the same as or different from each other. That is, the through-hole 18a and the through-hole 32a may partially overlap each other in the plane direction.

However, from the viewpoint of shortening the curing time of the conductive paste serving as the first filling member 36 to improve the productivity and reducing the use amount of the conductive paste to be used to reduce the cost, it is preferable that the through-hole 18a and the through-hole 32a completely overlap each other in the plane direction, including the configuration in which one through-hole includes the other through-hole.

In the example described above, both the through-hole 18a of the first protective layer 18 and the through-hole 32a of the first lead wire 32 have a cylindrical shape (columnar), but the present invention is not limited thereto.

For example, the through-hole 18a and/or the through-hole 32a may have a prism shape such as a triangular column or a square column or may have an elliptical columnar shape. That is, the shape of the through-hole is not limited as long as the through-hole 18a penetrates through the first protective layer 18 in the thickness direction and the through-hole 32a penetrates through the first lead wire 32 in the thickness direction.

However, from the viewpoints of ease of processing, ease of filling the through-hole with the conductive paste serving as the first filling member 36, and the like, it is preferable that the through-hole 18a and the through-hole 32a have a cylindrical shape.

Further, the through-hole 18a and/or the through-hole 32a may have a shape in which the size thereof in the plane direction gradually changes in the thickness direction.

For example, the through-hole 18a and/or the through-hole 32a may have a truncated conical shape, an elliptical frustum shape, a truncated pyramidal shape, or the like that gradually reduces in diameter or expands in diameter toward the piezoelectric layer 12. Even in this case, for the same reason as described above, a truncated conical shape is preferable as the shape of the through-hole.

The size of the through-hole 18a of the first protective layer 18 and the through-hole 32a of the first lead wire 32, for example, the diameter of the cylinder in the illustrated example is not limited.

That is, as the size of the through-hole 18a and the through-hole 32a, the size thereof that enables sufficient ensuring of the conductivity may be appropriately set according to the size of the piezoelectric film 30, the width of the band of the first lead wire 32, and the like.

Further, as illustrated in Figs. 3 and 4, in a case where the size of the through-hole 18a and the size of the through-hole 32a are different from each other, the difference in the size is also not limited. However, in the present invention, it is necessary to consider the difference in size between the through-hole 18a and the through-hole 32a, the amount of filling the through-hole 18a or the through-hole 32a with the conductive paste or the like, and the method of filling the through-hole 18a or the through-hole 32a with the conductive paste or the like as appropriate such that at least a part of the first filling member 36 with which the through-hole 18a is filled is reliably brought into contact with the inner wall surface of the through-hole 32a.

Further, a plurality of the through-holes 18a of the first protective layer 18 and/or a plurality of the through-holes 32a of the first lead wire 32 may be provided as necessary.

In this case, the number of through-holes 18a and through-holes 32a is not limited and may be appropriately set according to the size of the piezoelectric film 30, the size of the first lead wire 32, the conductivity required for connection, and the like. Further, the number of through-holes 18a and the number of through-holes 32a may be the same as or different from each other. For example, the number of through-holes 18a may be one and the number of through-holes 32a may be two or more.

Further, in a case where a plurality of through-holes 18a and/or a plurality of through-holes 32a are provided, one through-hole 18a and one through-hole 32a may overlap (include) each other, one through-hole 18a and a plurality of through-holes 32a may overlap each other, a plurality of through-holes 18a and one through-hole 32a may overlap each other, or a plurality of through-holes 18a and a plurality of through-holes 32a may overlap each other. Further, in the case where a plurality of through-holes 18a and/or a plurality of through-holes 32a are provided, through-holes that partially overlap (include) each other in the plane direction and through-holes that completely overlap each other in the plane direction may be mixed.

In the example described above, not only the through-hole 18a of the first protective layer 18 but also the through-hole 32a of the first lead wire 32 are filled with the first filling member 36.

However, the piezoelectric element according to the embodiment of the present invention is not limited thereto, and the through-hole 32a may be filled with at least a part of the first filling member 36 and at least the part thereof may be brought into contact with the inner wall surface of the through-hole 32a.

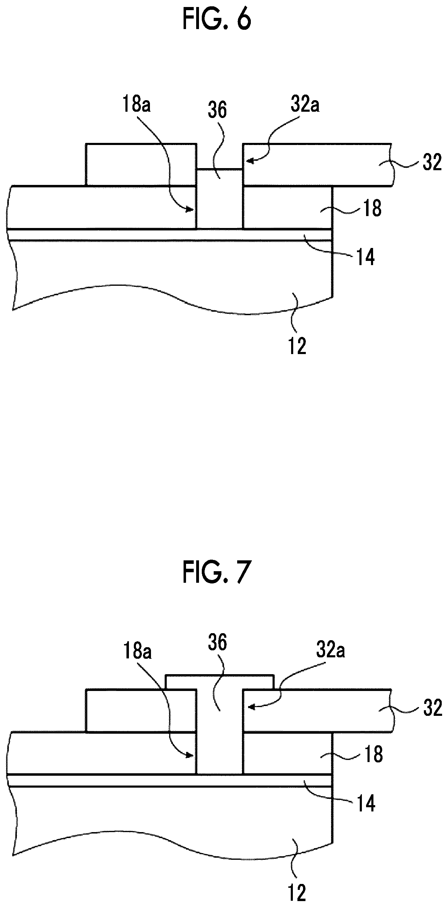

For example, as conceptually illustrated in Fig. 6, a configuration in which the through-hole 18a is filled with the first filling member 36 and the first filling member 36 reaches the middle of the through-hole 32a in the thickness direction may be employed.

However, from the viewpoint of increasing the contact area between the first filling member 36 and the first lead wire 32 and further reducing the resistance of the connection between the first electrode layer 14 and the first lead wire 32, it is preferable that the through-hole 18a and the through-hole 32a are filled with the first filling member 36.

Further, as conceptually illustrated in Fig. 7, the first filling member 36 may be brought into contact with the main surface of the first lead wire 32 on a side opposite to the side of the first protective layer 18 by filling the through-hole 18a of the first protective layer 18 and the through-hole 32a of the first lead wire 32 with the first filling member 36 such that the first filling member 36 overflows from the through-holes.

With such a configuration, the contact area between the first filling member 36 and the first lead wire 32 can be increased, and the resistance of the connection between the first electrode layer 14 and the first lead wire 32 can be further reduced.

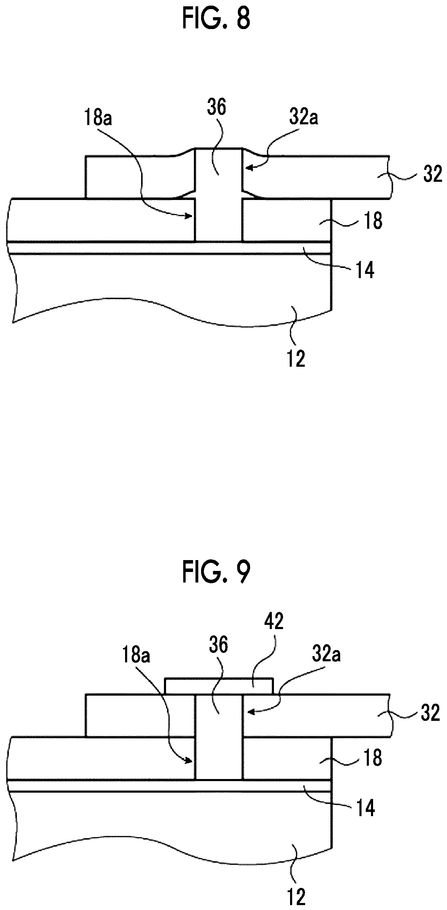

In addition, the first filling member 36 may be present between the first protective layer 18 and the first lead wire 32 as conceptually illustrated in Fig. 8. That is, the first filling member 36 may be brought into contact with the main surface of the first lead wire 32 on the side of the first protective layer 18. According to a preparation method of filling the through-hole 18a of the first protective layer 18 with the conductive filler which is the first filling member 36 and laminating the first lead wire 32 on the first protective layer 18, a piezoelectric element with this configuration can be easily prepared.

Similar to the configuration illustrated in Fig. 7, with such a configuration, the resistance of the connection between the first electrode layer 14 and the first lead wire 32 can be further reduced by increasing the contact area between the first filling member 36 and the first lead wire 32.

Further, the configuration illustrated in Fig. 7 and the configuration illustrated in Fig. 8 may be used in combination.

In the piezoelectric element 10 according to the embodiment of the present invention, the first filling member 36 (second filling member 38) is not limited, and various known conductive materials can be used as long as the through-holes can be filled with the conductive materials.

In the present invention, as a preferred example, the first filling member 36 is formed of a conductive paste that contains a conductive filler, a binder (resin), a solvent, and the like and is cured by volatilization of the solvent.

As the conductive paste used in the present invention, various known conductive pastes can be used as long as the conductive pastes contain a conductive filler, a binder, and a solvent and are cured by volatilization of the solvent. Examples thereof include a silver paste, a copper paste, a nickel paste, a carbon paste, and a gold paste.

In addition, commercially available products such as DOTITE Series (manufactured by Fujikura Kasei Co., Ltd.) can also be suitably used as the conductive paste.

The first lead wire 32 (second lead wire 34) is also not limited, and various known lead wires (conducting wires) used for electrical connection between two points can be used. Examples of the lead wire include copper foil, a lead wire obtained by performing conductive plating with nickel or the like on the surface of copper foil, and a lead wire obtained by patterning a film-like base material such as a flexible printed circuit (FPC) substrate with a conductor such as copper.

Further, the shape of the first lead wire 32 is not limited to a plate shape (strip shape), and a rod shape or the like may be employed as long as the through-hole 32a can be formed.

In the piezoelectric element according to the embodiment of the present invention, the conductive member for connecting the electrode layer of the piezoelectric film and an external device such as a power supply device is not limited to the lead wire, and various conductive members can be used as long as the electrode layer and the external device can be electrically connected.

Examples of the conductive member other than the lead wire include an FPC substrate.

However, in any of the conductive members, the through-holes provided in the conductive member are required to include at least a part of the conductive portion of the conductive member such as the wire.

In addition, it is preferable that the conductive member, including the first lead wire 32, has flexibility regardless of the material and the form.

In the piezoelectric element 10 according to the embodiment of the present invention, the surface roughness Ra (arithmetic average roughness Ra) of the surface of the first lead wire 32 (second lead wire 34 (conductive member)) in contact with the first protective layer 18 is preferably 0.8 $\mu$m or greater.

Further, the surface for the surface roughness Ra is not necessarily to be the entire surface of the contact surface of the first lead wire 32 with the first protective layer 18. That is, the surface roughness Ra of the contact portion between the first lead wire 32 with at least the first filling member 36 may be 0.8 $\mu$m or greater in the contact surface between the first lead wire 32 and the first protective layer 18.

In the piezoelectric element 10 according to the embodiment of the present invention, it is preferable that the first filling member 36 is also present between the first protective layer 18 and the first lead wire 32, as in the configuration illustrated in Fig. 8.

In a case where the surface roughness Ra of the surface of the first lead wire 32 in contact with the first protective layer 18 is 0.8 $\mu$m or greater, the contact area between the first filling member 36 and the first lead wire 32 can be further increased. As a result, the resistance of the connection between the first electrode layer 14 and the first lead wire 32 can be further decreased.

Further, as illustrated in Fig. 3, even in a case where the through-hole 18a of the first protective layer 18 is larger than the through-hole of the first lead wire 32, the contact area between the first filling member 36 and the first lead wire 32 can be further increased in a case where the surface roughness Ra of the surface of the first lead wire 32 in contact with the first protective layer 18 is 0.8 $\mu$m or greater. As a result, the resistance of the connection between the first electrode layer 14 and the first lead wire 32 can be further decreased.

The surface roughness Ra of the surface of the first lead wire 32 in contact with the first protective layer 18 is more preferably 1.0 $\mu$m or greater. The upper limit of the surface roughness Ra of the surface of the first lead wire 32 in contact with the first protective layer 18 is not limited, but is preferably 100 $\mu$m or less.

Further, in a case where the contact surface of the first lead wire 32 with the first protective layer 18 is roughened as necessary, the roughening treatment may be performed by a known method.

Examples of a method of performing the roughening treatment on the first lead wire 32 include sand blasting and etching.

The surface roughness Ra of the surface of the first lead wire 32 in contact with the first protective layer 18 may be determined by measuring the surface roughness Ra (arithmetic average roughness Ra) in conformity with JIS B 0601:1994.

Further, the surface roughness Ra of the surface of the first lead wire 32 in contact with the first protective layer 18 may be measured, for example, before the first lead wire 32 is bonded to the first protective layer 18.

In addition, as described above, the surface roughness Ra of the contact portion between the first lead wire 32 with at least the first filling member 36 may be 0.8 $\mu$m or greater. However, the surface roughness of the surface of the first lead wire 32 in contact with the first protective layer 18 is typically uniform over the entire surface. Therefore, in the completed piezoelectric element 10, the surface roughness Ra of the surface of the first lead wire 32 in contact with the first protective layer 18 may be measured by using a portion protruding from the piezoelectric film 30.

The position where the first lead wire 32 (second lead wire 34) is mounted is also not limited and may be any position in the first protective layer 18 as long as the position is in contact with the first protective layer 18 (second protective layer 20) and can protrude from the piezoelectric film 30 in the plane direction according to the length or the like of the first lead wire 32.

Here, as described above, the piezoelectric film 30 is extremely thin. Therefore, in a case where the first lead wire 32 and the second lead wire 34 are close to each other in the plane direction, there is a possibility that the lead wires come into contact with each other and cause a short circuit.

Therefore, it is preferable that the first lead wire 32 and the second lead wire 34 are provided to be separated from each other in the plane direction so that the first lead wire 32 and the second lead wire 34 do not overlap each other in the plane direction. Further, the expression "the first lead wire 32 and the second lead wire 34 do not overlap each other in the plane direction" denotes that the first lead wire 32 and the second lead wire 34 do not seem to overlap each other in a case of being viewed in a direction orthogonal to the main surface of the piezoelectric film 30.

The piezoelectric element according to the embodiment of the present invention may include a protective member 42 for protecting the first filling member 36 (second filling member 38) by covering the first filling member 36, on the surface of the first lead wire 32 (second lead wire 34), as conceptually illustrated in Fig. 9.

In a case where the piezoelectric element includes such a protective member 42, it is possible to protect the first filling member 36 and further prevent corrosion of the first filling member 36. Further, the corrosion of the first electrode layer 14 (second electrode layer 16) can be prevented and the first electrode layer 14 can be protected by preventing the corrosion of the first filling member 36.

The protective member 42 is not limited, and various known sheet-like materials can be used as long as the protective member 42 has an insulating property and preferably a gas barrier property (steam barrier property) to some extent.

Examples thereof include bonding tape made of polyimide and an insulating and moistureproof coating material. As such materials, commercially available products can also be suitably used.

The size of the protective member 42 is not limited and may be appropriately set such that the through-hole 32a of the first lead wire 32 or the first filling member 36 present on the main surface of the first lead wire 32 can be sufficiently covered by the protective member according to the size of the through-holes.

In addition, the thickness of the protective member 42 is not limited, and the thickness that enables the target function to be sufficiently exhibited may be appropriately set according to the material for forming the protective member 42.

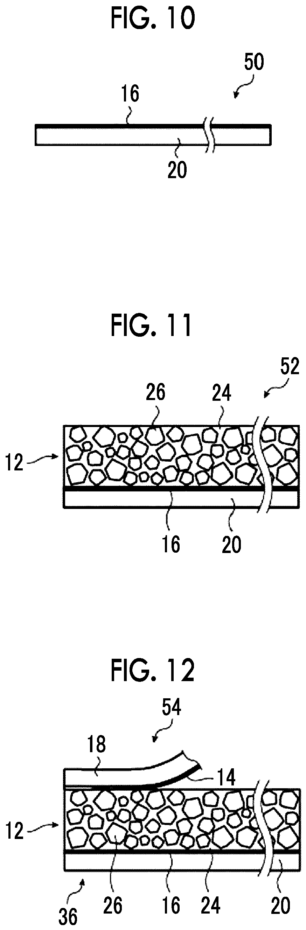

Next, an example of the method of producing the piezoelectric element 10 illustrated in Fig. 1 will be described with reference to the conceptual views of Figs. 10 to 16.

First, as illustrated in Fig. 10, a sheet-like material 50 in which the second electrode layer 16 is formed on the second protective layer 20 is prepared. The sheet-like material 50 may be prepared by forming a copper thin film or the like as the second electrode layer 16 on the surface of the second protective layer 20 by carrying out vacuum vapor deposition, sputtering, plating, or the like.

In a case where the second protective layer 20 is extremely thin and thus the handleability is degraded, the second protective layer 20 with a separator (temporary support) may be used as necessary. Further, a PET having a thickness of 25 to 100 $\mu$m or the like can be used as the separator. The separator may be removed after thermal compression bonding of the first electrode layer 14 and the first protective layer 18 and before lamination of any member on the first protective layer 18.

Meanwhile, the coating material is prepared by dissolving a polymer material having a viscoelasticity at room temperature, such as cyanoethylated PVA, in an organic solvent, adding the piezoelectric particles 26 such as PZT particles thereto, and stirring the solution for dispersion. In the following description, the polymer material having a viscoelasticity at room temperature, such as cyanoethylated PVA, will also be referred to as "viscoelastic material".

The organic solvent is not limited, and various organic solvents such as dimethylformamide (DMF), methyl ethyl ketone, and cyclohexanone can be used.

In a case where the sheet-like material 50 is prepared and the coating material is prepared, the coating material is cast (applied) onto the sheet-like material 50, and the organic solvent is evaporated and dried. In this manner, as illustrated in Fig. 11, a laminate 52 in which the second electrode layer 16 is provided on the second protective layer 20 and the piezoelectric layer 12 is formed on the second electrode layer 16 is prepared.

A casting method for the coating material is not particularly limited, and all known coating methods (coating devices) such as a slide coater and a doctor knife can be used.

Further, in a case where the viscoelastic material is a material that can be heated and melted, such as cyanoethylated PVA, the laminate 52 in which the second electrode layer 16 is provided on the second protective layer 20 and the piezoelectric layer 12 is formed on the second electrode layer 16 as illustrated in Fig. 11 may be prepared by heating and melting the viscoelastic material to prepare a melt obtained by adding the piezoelectric particles 26 to the melt to be dispersed therein, extruding the melt on the sheet-like material 50 illustrated in Fig. 10 in a sheet shape by carrying out extrusion molding or the like, and cooling the laminate.

As described above, in the piezoelectric element 10, in addition to the viscoelastic material such as cyanoethylated PVA, a dielectric polymer material such as polyvinylidene fluoride may be added to the matrix 24. In a case where the polymer piezoelectric material is added to the matrix 24, the polymer piezoelectric material to be added to the coating material may be dissolved. Alternatively, the polymer piezoelectric material to be added may be added to the heated and melted viscoelastic material so that the polymer piezoelectric material is heated and melted.

In a case where the laminate 52 in which the second electrode layer 16 is provided on the second protective layer 20 and the piezoelectric layer 12 is formed on the second electrode layer 16 is prepared, the piezoelectric layer 12 is subjected to a polarization treatment (poling).

A method of performing the polarization treatment on the piezoelectric layer 12 is not limited, and a known method can be used. For example, electric field poling in which a DC electric field is directly applied to a target to be subjected to the polarization treatment is exemplified. Further, in a case of performing electric field poling, the electric field poling treatment may be performed using the first electrode layer 14 and the second electrode layer 16 by forming the first electrode layer 14 before the polarization treatment.

Further, in a case where the piezoelectric element 10 according to the embodiment of the present invention is produced, it is preferable that the polarization treatment is performed in the thickness direction of the piezoelectric layer 12 instead of the plane direction.

Before the polarization treatment, a calender treatment may be performed to smoothen the surface of the piezoelectric layer 12 using a heating roller or the like. By performing the calender treatment, a thermal compression bonding step described below can be smoothly performed.

Meanwhile, a sheet-like material 54 in which the first electrode layer 14 is formed on the first protective layer 18 is prepared. The sheet-like material 54 may be the same as the sheet-like material 50 described above.

Next, as illustrated in Fig. 12, the sheet-like material 54 is laminated on the laminate 52 in which the polarization treatment performed on the piezoelectric layer 12 is completed in a state where the first electrode layer 14 is directed to the piezoelectric layer 12.

Further, a laminate of the laminate 52 and the sheet-like material 54 is sandwiched between the second protective layer 20 and the first protective layer 18, and is subjected to the thermal compression bonding using a heating press device, a pair of heating rollers, or the like, thereby preparing the piezoelectric film 30 as illustrated in Fig. 1.

Alternatively, the piezoelectric film 30 may be prepared by bonding and preferably further compression-bonding the laminate 52 and the sheet-like material 54 to each other using an adhesive.

The piezoelectric film 30 to be prepared in the above-described manner is polarized in the thickness direction instead of the plane direction, and thus excellent piezoelectric characteristics are obtained even in a case where the stretching treatment is not performed after the polarization treatment. Therefore, the piezoelectric film 30 has no in-plane anisotropy as a piezoelectric characteristic, and stretches and contracts isotropically in all directions in the in-plane direction in a case where a driving voltage is applied.

Such a piezoelectric film 30 may be produced by using a cut sheet-like material 50, a sheet-like material 54, and the like or by using a long sheet-like material 50, a sheet-like material 54, and the like according to roll-to-roll (Roll to Roll).

Next, the first lead wire 32 is mounted on the first protective layer 18 of the piezoelectric film 30, and the second lead wire 34 is mounted on the second protective layer 20.

Further, since the mounting of the first lead wire 32 and the mounting of the second lead wire 34 can be performed in the same manner, the mounting of the first lead wire 32 will be described as a representative example in the same manner as described above.

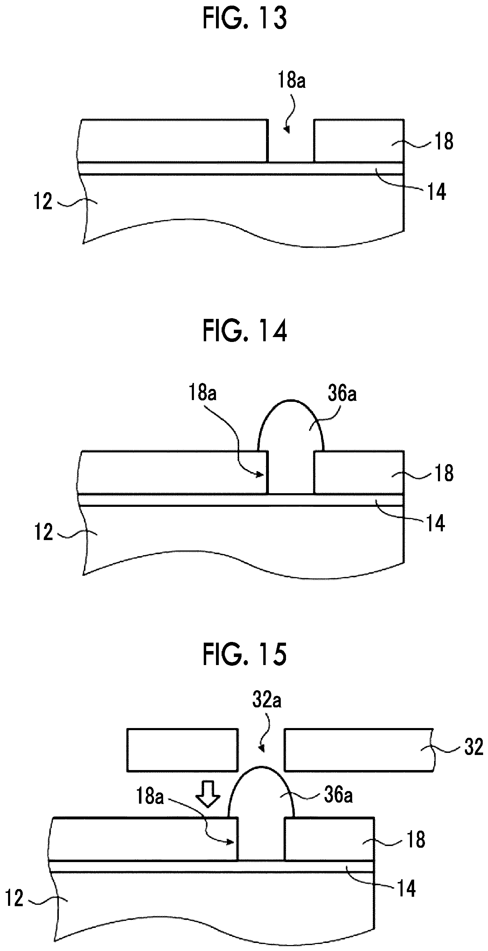

First, as illustrated in Fig. 13, a through-hole 18a (through-hole 20a) is formed in the first protective layer 18 (second protective layer 20).

The method of forming the through-hole 18a is not limited, and a known method may be used depending on the material for forming the first protective layer 18. Examples of the method of forming the through-hole 18a include methods such as laser processing, dissolution removal using a solvent, and mechanical processing such as mechanical polishing.

Next, as illustrated in Fig. 14, the through-hole 18a is filled with a material serving as the first filling member 36, for example, a conductive paste 36a.

Further, the through-hole 18a is filled with the conductive paste 36a and it is preferable that the through-hole 32a of the first lead wire 32 is also filled with a sufficient amount of the conductive paste 36a.

Meanwhile, the first lead wire 32 (second lead wire 34) in which the through-hole 32a (through-hole 34a) is formed is prepared. The method of forming the through-hole 32a is not limited, and a known method may be used depending on the material for forming the first lead wire 32. Examples of the method of forming the through-hole 32a include methods such as laser processing and mechanical processing such as mechanical polishing and punching.

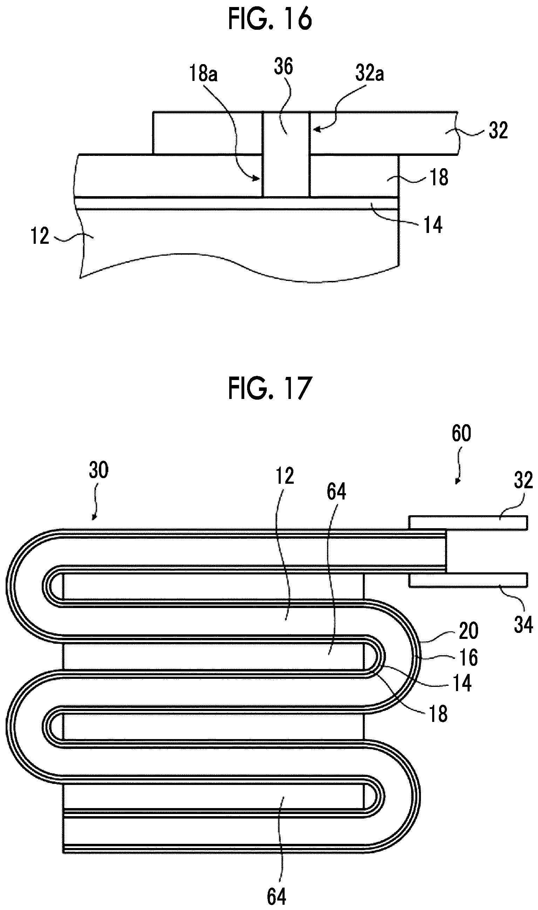

Next, as illustrated in Figs. 15 and 16, the through-hole 18a of the first protective layer 18 and the through-hole 32a of the first lead wire 32 are positioned, and the first lead wire 32 is laminated on the first protective layer 18.

In this manner, the conductive paste 36a flows into the through-hole 32a and it is preferable that the through-hole 32a is filled with the conductive paste 36a. Further, in a case where the through-holes 32a cannot be filled with the conductive paste 36a, the through-holes 32a may be further filled with the conductive paste 36a, as necessary.

Further, although not illustrated, the conductive paste 36a is also extruded between the first protective layer 18 and the first lead wire 32 during the lamination. Further, it is preferable that the conductive paste 36a overflows from the through-holes 32a during the lamination and comes into contact with the main surface of the first lead wire 32 on a side opposite to the side of the first protective layer 18. Further, the excess conductive paste 36a that overflows from the through-hole 32a may be removed by being wiped or the like, as necessary.

Finally, the piezoelectric element 10 is completed using the conductive paste 36a as the first filling member 36 (second filling member 38) by volatilizing the solvent of the conductive paste 36a and curing the paste.

Here, in the piezoelectric element 10 according to the embodiment of the present invention, since the first lead wire 32 has the through-hole 32a, the conductive paste 36a is opened to the atmosphere as described above, and the volatilization of the solvent that is, curing of the conductive paste 36a can be carried out quickly. As a result, in the piezoelectric element 10 according to the embodiment of the present invention, the electrode layer and the lead wire can be connected to each other with high productivity.

Further, although not illustrated, according to the production method, since the first filling member 36 (conductive paste 36a) is provided between the first protective layer 18 and the first lead wire 32, the contact area between the first filling member 36 and the first lead wire 32 can be increased and the resistance of the connection between the electrode layer and the lead wire can be reduced, as illustrated in Fig. 8. It is preferable that the first filling member 36 (conductive paste 36a) is brought into contact with the main surface of the first lead wire 32 on the side opposite to the side of the first protective layer 18 from the viewpoint that the contact area between the first filling member 36 and the first lead wire 32 can be increased and the resistance of the connection between the electrode layer and the lead wire can be reduced.

In the piezoelectric element 10 according to the embodiment of the present invention, the first protective layer 18 (second protective layer 20) and the first lead wire 32 (second lead wire 34) may be bonded to each other by a known method.

As an example, the first protective layer 18 and the first lead wire 32 may be bonded to each other by using the bonding force of the first filling member 36 (second filling member 38), that is, the conductive paste 36a or the like. In addition, the first protective layer 18 and the first lead wire 32 may be bonded to each other by using a bonding layer consisting of an adhesive, a pressure sensitive adhesive (pressure sensitive adhesive sheet), or the like. Further, the first protective layer 18 and the first lead wire 32 may be bonded to each other by covering at least a part of the first lead wire 32 and bonding bonding tape to the first lead wire 32 and the first protective layer 18. Alternatively, the first protective layer 18 and the first lead wire 32 may be bonded to each other by using a plurality of these methods in combination. Further, in the method of covering at least a part of the first lead wire 32 and bonding bonding tape to the first lead wire 32 and the first protective layer 18, the bonding tape may be provided to cover the first filling member 36 so that the bonding tape acts as the protective member 42 described above.

The method of producing the piezoelectric element according to the embodiment of the present invention is not limited to the method illustrated in Figs. 10 to 16, and various methods can be used.

For example, as illustrated in Fig. 14, the first lead wire 32 may be laminated on the first protective layer 18 before the through-hole 18a is filled with the conductive paste 36a, and the through-hole 18a and the through-hole 32a may be filled with the conductive paste 36a which is the first filling member.

However, in this production method, since the first filling member 36 is difficult to provide between the first protective layer 18 and the first lead wire 32, the production method illustrated in Figs. 10 to 16 described above is more advantageous from this viewpoint.

As an example, the piezoelectric element 10 according to the embodiment of the present invention can be suitably used as an electroacoustic transducer (electroacoustic conversion film).

In the piezoelectric element 10, the piezoelectric film 30 is stretched and contracted in the plane direction by applying a driving voltage to the first electrode layer 14 and the second electrode layer 16.

Such a piezoelectric element 10 is held in a state where the piezoelectric film 30 is curved. In the piezoelectric film 30 held in a curved state, in a case where the piezoelectric film is stretched in the plane direction due to application of a voltage to the piezoelectric film 30, the piezoelectric film 30 moves to a projection side in order to absorb the stretched part. On the contrary, in a case where the piezoelectric film 30 is contracted in the plane direction due to application of a voltage to the piezoelectric film 30, the piezoelectric film 30 moves to a recess side in order to absorb the contracted part.

That is, the movement of the piezoelectric film 30 to stretch and contract can be converted into vibration of the piezoelectric film 30 in the thickness direction by holding the piezoelectric film 30 in a curved state.

The piezoelectric element 10 can convert the vibration (sound) and the electric signal by the vibration of the piezoelectric film caused by the repeated stretch and contraction of the film.

As described above, the piezoelectric element 10 according to the embodiment of the present invention can be used for the piezoelectric speaker that reproduces a sound by vibration according to an electric signal input to the piezoelectric film 30 and a voice sensor that converts the vibration of the piezoelectric film 30 caused by receiving a sound wave into an electric signal. Further, the piezoelectric element 10 according to the embodiment of the present invention can also be used as a vibration sensor that detects vibration other than sound waves.

The piezoelectric speaker formed of the piezoelectric element 10 can be stored in a bag or the like by, for example, being rolled or folded using the satisfactory flexibility. Therefore, with the piezoelectric element 10, a piezoelectric speaker that can be easily carried even in a case where the piezoelectric speaker has a certain size can be realized.

Further, as described above, the piezoelectric element 10 has excellent elasticity and excellent flexibility, and has no in-plane anisotropy as a piezoelectric characteristic. Therefore, in the piezoelectric element 10, a change in acoustic quality regardless of the direction in which the element is bent is small, and a change in acoustic quality with respect to the change in curvature is also small. Accordingly, the piezoelectric speaker formed of the piezoelectric element 10 has a high degree of freedom of the installation place and can be attached to various products as described above. For example, a so-called wearable speaker can be realized by mounting the piezoelectric element 10 on clothing such as a suit and portable items such as a bag in a curved state.

Further, as described above, the piezoelectric element 10 according to the embodiment of the present invention can be used as a speaker of a display device having flexibility by bonding the piezoelectric element 10 to a display device having flexibility such as an organic EL display device having flexibility or a liquid crystal display device having flexibility.

Further, the speaker formed of the piezoelectric element 10 according to the embodiment of the present invention is not limited to such a flexible speaker, and various known configurations can be used.

As illustrated in Fig. 3 of JP2015-109627A, a speaker obtained by storing a viscoelastic support such as wool felt or glass wool in a case having an open upper surface and pressing and fixing the viscoelastic support with the piezoelectric film of the piezoelectric element 10 according to the embodiment of the present invention is described as an example.

The piezoelectric element according to the embodiment of the present invention may be formed by laminating a plurality of layers of the piezoelectric film 30.

As the piezoelectric element according to the embodiment of the present invention in which a plurality of layers of the piezoelectric film 30 are laminated, a configuration of the piezoelectric element 10 illustrated in Figs. 1 and 2, in which a plurality of layers of the piezoelectric film 30 are laminated and preferably bonded to each other with a bonding layer described below is described as an example.

As the piezoelectric element according to the embodiment of the present invention in which a plurality of layers of the piezoelectric film 30 are laminated, a piezoelectric element in which a plurality of layers of the piezoelectric film 30 are laminated by folding one sheet of the piezoelectric film 30 once or more and preferably a plurality of times as in the example of a piezoelectric element 60 conceptually illustrated in Fig. 17 is preferably exemplified. Although a plurality of layers of the piezoelectric film 30 are laminated by folding and laminating one piezoelectric film 30, the number of the first lead wire 32 and the number of the second lead wire 34 may be one.

As described above, the piezoelectric film 30 of the piezoelectric element 10 stretches and contracts in the plane direction in a case where a voltage is applied, and vibrates suitably in the thickness direction due to the stretch and contraction in the plane direction, and thus a satisfactory acoustic characteristic of outputting a sound with a high sound pressure is exhibited in a case where the piezoelectric element is used as a piezoelectric speaker or the like.

The piezoelectric film 30, which exhibits satisfactory acoustic characteristics, that is, high stretch and contraction performance due to piezoelectricity is satisfactorily operated as a piezoelectric vibrating element that vibrates a vibration body such as a vibration plate by laminating a plurality of layers of the piezoelectric film 30.

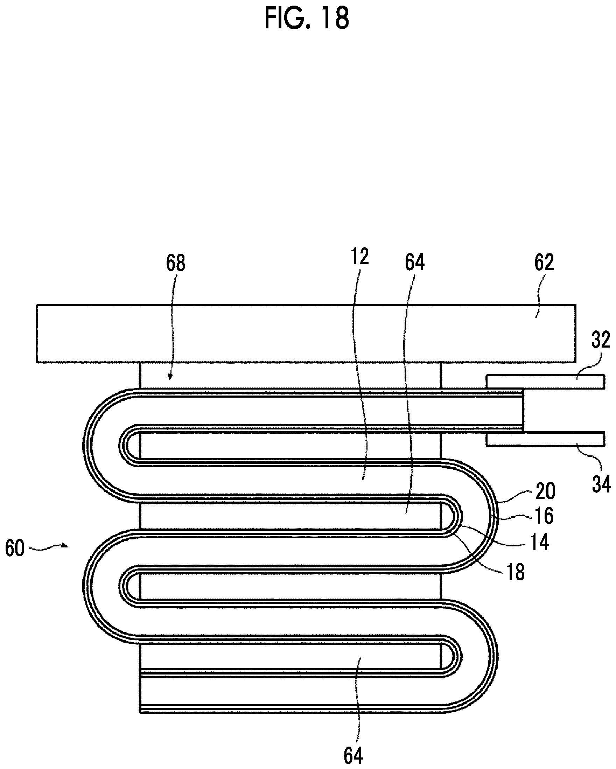

As an example, as conceptually illustrated in Fig. 18, the piezoelectric element 60 on which the piezoelectric film 30 is laminated may be used as a speaker in which the piezoelectric element 60 is bonded to a vibration plate 62, and the vibration plate 62 is vibrated by the laminate of the piezoelectric film 30 to output a sound. That is, in this case, the laminate of the piezoelectric element 60 formed by laminating the piezoelectric film 30 acts as a so-called exciter that outputs a sound by vibrating the vibration plate 62.

By applying a driving voltage to the laminated piezoelectric films 30, each layer of the piezoelectric film 30 stretches and contracts in the plane direction, and the entire laminated layers of the piezoelectric film 30 stretches and contracts in the plane direction due to the stretch and contraction of each layer of the piezoelectric film 30.

The vibration plate 62 to which the laminate has been bonded is bent due to the stretch and contraction of the laminate of the piezoelectric film 30 in the plane direction, and thus the vibration plate 62 vibrates in the thickness direction. The vibration plate 62 generates a sound using the vibration in the thickness direction. The vibration plate 62 vibrates according to the magnitude of the driving voltage applied to the piezoelectric element 60 and generates a sound according to the driving voltage applied to the piezoelectric element 60.

Therefore, in this case, the piezoelectric element 60 (piezoelectric film 30) itself does not output a sound.

Therefore, even in a case where the rigidity of each piezoelectric film 30 is low and the stretching and contracting force thereof is small, the rigidity is increased by laminating the piezoelectric films 30, and the stretching and contracting force as the entire laminate is increased.

As a result, in the piezoelectric element 60 which is the laminate of the piezoelectric film 30, even in a case where the vibration plate 62 has a certain degree of rigidity, the vibration plate 62 is sufficiently bent with a large force and the vibration plate 62 can be sufficiently vibrated in the thickness direction, whereby the vibration plate 62 can generate a sound.

In the piezoelectric element 60 formed by laminating the piezoelectric film 30, the number of laminated sheets of the piezoelectric films 30 is not limited, and the number of sheets set such that a sufficient amount of vibration is obtained may be appropriately set according to, for example, the rigidity of the vibration plate 62 to be vibrated.

Further, one sheet of the piezoelectric element 10 as illustrated in Figs. 1 and 2 can also be used as a similar exciter (piezoelectric vibration element) as long as the piezoelectric element 10 has a sufficient stretching and contracting force.

In Figs. 17 and 18, the reference numeral 64 represents a bonding layer that bonds adjacent layers of the piezoelectric film 30 in the lamination direction.

As described above, the piezoelectric element 60 generates a sound by allowing a plurality of laminated layers of the piezoelectric film 30 to be stretched and contracted to vibrate the vibration plate 46. Therefore, in the piezoelectric element 60 according to the embodiment of the present invention formed by laminating a plurality of laminated layers of the piezoelectric film 30, it is preferable that the stretch and contraction of the piezoelectric film 30 of each layer is directly transmitted. In this regard, in a case where the piezoelectric element has the bonding layer 64 that bonds adjacent layers of the piezoelectric film 30, the stretch and contraction of the piezoelectric film 30 of each layer can be directly transmitted, and the stretch and contraction and the driving efficiency of the entire piezoelectric element 60 can be significantly improved.

Further, the bonding layer 64 is not an essential configuration requirement in the piezoelectric element according to the embodiment of the present invention which is formed by laminating a plurality of layers of the piezoelectric film 30.

However, in a case where the bonding layer 64 is not provided, each layer of the piezoelectric film 30 independently stretches and contracts. As described above, in a case where the individual layers of the piezoelectric film 30 independently stretch and contract, the driving efficiency of the laminated piezoelectric element decreases, the degree of stretching and contracting of the entire laminated piezoelectric element decreases, and there is a possibility that the vibration plate 62 or the like in contact cannot be sufficiently vibrated.

Therefore, it is preferable that the piezoelectric element according to the embodiment of the present invention which is formed by laminating a plurality of layers of the piezoelectric film 30 includes the bonding layer 64 that bonds adjacent layers of the piezoelectric film 30 as illustrated in Fig. 17 and the like.

In the present invention, various known layers can be used as the bonding layer 64 as long as the adjacent layers of the piezoelectric film 30 can be bonded to each other.

Therefore, the bonding layer 64 may be a layer consisting of an adhesive, a layer consisting of a pressure sensitive adhesive, or a layer consisting of a material having characteristics of both an adhesive and a pressure sensitive adhesive. The adhesive is a bonding agent that has fluidity in a case of bonding layers and enters a solid state. The pressure sensitive adhesive is a bonding agent which is a gel-like (rubber-like) flexible solid in a case of bonding layers and whose gel-like state does not change thereafter.

Here, in the piezoelectric element which is formed by laminating a plurality of layers of the piezoelectric film 30 as described above, it is preferable that the stretch and contraction of the piezoelectric film 30 of each layer is directly transmitted. In consideration of this point, it is preferable that the bonding layer 64 is an adhesive layer consisting of an adhesive from which a solid and hard bonding layer 64 is obtained, rather than a pressure sensitive adhesive layer consisting of a pressure sensitive adhesive.

In the piezoelectric element 60, the thickness of the bonding layer 64 is not limited, and the thickness thereof that enables exhibition of a sufficient magnitude of bonding strength (adhesive strength or pressure sensitive adhesive strength) may be appropriately set according to the adhesive layer or the like that forms the bonding layer 64.

In regard to the bonding layer 64 described above and the bonding layer 68 described below, the same applies to the piezoelectric element according to the embodiment of the present invention in which a plurality of layers of the piezoelectric element 10 illustrated in Figs. 1 and 2 are laminated, that is, the piezoelectric element according to the embodiment of the present invention in which a plurality of layers of the cut sheet-like piezoelectric films 30 are laminated.

In a case where the piezoelectric element formed by laminating a plurality of layers of the piezoelectric film 30 is used as an exciter, the vibration plate vibrated by the laminate of the piezoelectric element 10 is not limited, and various sheet-like materials (plate-like materials or films) can be used without limitation.

Examples thereof include a resin film consisting of polyethylene terephthalate (PET) and the like, foamed plastic consisting of foamed polystyrene and the like, a paper material such as a corrugated cardboard material, a glass plate, and wood. Further, a device such as a display device may be used as the vibration plate in a case where the device can be sufficiently bent.

In Fig. 18, the reference numeral 68 represents a bonding layer for bonding the piezoelectric element 60 according to the embodiment of the present invention and the vibration plate 62 to each other, which is provided as a preferable aspect. In a case where the piezoelectric element 60 includes the bonding layer 68 for bonding the piezoelectric element 60 and the vibration plate 62 to each other, the stretch and contraction of the piezoelectric element 60 (laminate of the piezoelectric film 30) is directly transmitted to the vibration plate 62, and the vibration plate 62 can be efficiently vibrated.

In the electroacoustic transducer formed of the piezoelectric element 60 according to the embodiment of the present invention as an exciter, the bonding layer 68 for bonding the piezoelectric element 60 and the vibration plate 62 is not limited, and layers consisting of various known pressure sensitive adhesives and adhesives can be used.

As an example of the material for forming the bonding layer 68, the same materials as those of the bonding layer 64 described above are exemplified. The preferable bonding layer 68 (bonding agent) is also the same as the bonding layer 64.

Hereinbefore, the piezoelectric element according to the embodiment of the present invention has been described in detail, but the present invention is not limited to the above-described examples, and various improvements or modifications may be made within a range not departing from the scope of the present invention.

Examples

Hereinafter, a piezoelectric element according to the embodiment of the present invention will be described in more detail with reference to specific examples of the present invention.

[Preparation of piezoelectric film]

Lead oxide powder, zirconium oxide powder, and titanium oxide powder were wet-mixed in a ball mill for 12 hours to prepare raw material mixed powder. Here, the amount of each oxide was set to Zr = 0.52 mol and Ti = 0.48 mol with respect to Pb = 1 mol.

This raw material mixed powder was put into a crucible and fired at 800°C for 5 hours, thereby preparing raw material particles of PZT particles.

By the method illustrated in Figs. 10 to 12 described above, a piezoelectric film as illustrated in Fig. 1 which had electrode layers on both surfaces of the piezoelectric layer and had protective layers covering the electrode layers was prepared.

First, cyanoethylated PVA (CR-V, manufactured by Shin-Etsu Chemical Co., Ltd.) was dissolved in methyl ethyl ketone (MEK) at the following compositional ratio. Thereafter, PZT particles were added to the solution at the following compositional ratio and dispersed using a propeller mixer (rotation speed of 2000 rpm), thereby preparing a coating material for forming a piezoelectric layer.

· PZT Particles ⋯ 300 parts by mass
· Cyanoethylated PVA ⋯ 30 parts by mass
· DMF ⋯ 70 parts by mass

Further, two sheets of sheet-like materials obtained by performing vacuum vapor deposition on a copper thin film having a thickness of 0.1 μm were prepared on a PET film having a thickness of 4 μm. That is, in the present example, the first electrode layer and the second electrode layer are copper-deposited thin films having a thickness of 0.1 m, and the first protective layer and the second protective layer are PET films having a thickness of 4 μm.

The second electrode layer (copper-deposited thin film) of one sheet-like material was coated with the coating material for forming the piezoelectric layer prepared in advance using a slide coater. Further, the second electrode layer was coated the coating material such that the film thickness of the coating film after being dried reached 40 $\mu$m.

Next, the material obtained by coating the sheet-like material with the coating material was heated and dried on a hot plate at 120°C to evaporate DMF. In this manner, a laminate in which the second electrode layer made of copper was provided on the second protective layer made of PET and the piezoelectric layer having a thickness of 40 $\mu$m was provided thereon was prepared.

The prepared piezoelectric layer was subjected to a polarization treatment in the thickness direction.

The other sheet-like material was laminated on the laminate subjected to a polarization treatment in a state where the first electrode layer (copper thin film side) was directed to the piezoelectric layer.

Next, a piezoelectric film as illustrated in Fig. 1 was prepared by performing thermal compression bonding on the laminate of the laminate and the sheet-like material at a temperature of 120°C using a laminator device, and bonding and adhering the piezoelectric layer and the first electrode layer to each other.

The prepared piezoelectric film was cut into a rectangle having a size of 200 $\times$ 70 mm.

[Example 1]

A first lead wire and a second lead wire each having a thickness of 35 $\mu$m, a width of 12 mm, and a length of 15 mm were prepared. This lead wire was obtained by performing nickel plating with a thickness of 0.5 $\mu$m on the surface of copper foil.

A through-hole having a diameter of 5 mm was provided by a punching machine in the vicinity of an end portion of the lead wire in the length direction and at the center in the width direction.

A through-hole having a diameter of 5 mm was formed in the first protective layer of the cut piezoelectric film using a carbon dioxide gas laser. The through-hole was formed such that the center of the through-hole was at a position separated by 10 mm from one end portion of the piezoelectric film in the longitudinal direction and separated by 20 mm from one end portion thereof in the lateral direction.

The through-hole was filled with a conductive paste (DOTITE D550, (manufactured by Fujikura Kasei Co., Ltd.). The filling amount of the conductive paste was set such that not only the through-hole of the protective layer but also the through-hole of the first lead wire were sufficiently filled with the conductive paste. In this regard, the same applies to other examples depending on the diameter and the like of the through-hole of the lead wire.

Next, the first lead wire was laminated and mounted on the first protective layer by allowing the centers of the through-holes to coincide with each other in the plane direction.

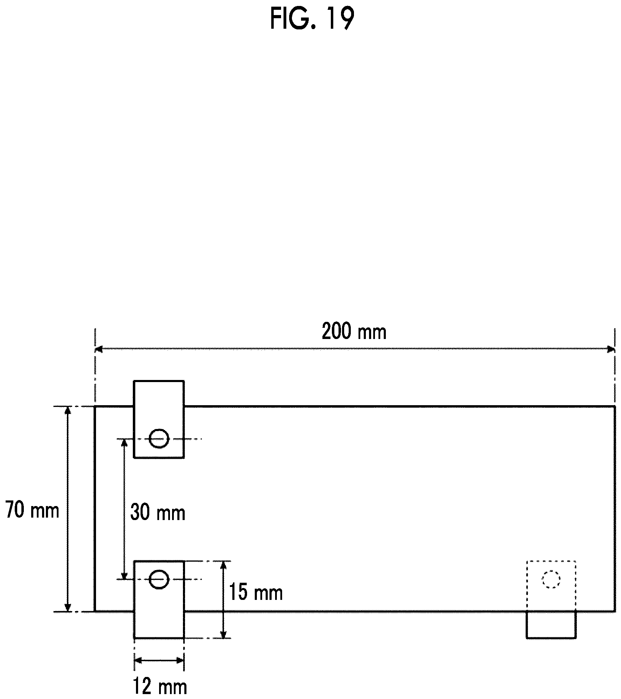

A piezoelectric element as illustrated in Figs. 1 and 2 was prepared (see Fig. 19) by laminating and mounting the second lead wire on the second protective layer in the same manner as that for the first lead wire such that the centers of the through-holes were at positions to be line-symmetric with respect to the center of the piezoelectric film in the longitudinal direction.

[Example 2]

A piezoelectric element was prepared in the same manner as in Example 1 except that the diameter of the through-hole of the lead wire was set to 2 mm.

That is, the piezoelectric element has a configuration in which the through-hole of the protective layer includes the through-hole of the lead wire in the plane direction as in the example illustrated in Fig. 3.

[Example 3]

A piezoelectric element was prepared in the same manner as in Example 1 except that the diameter of the through-hole of the lead wire was set to 8 mm.

That is, the piezoelectric element has a configuration in which the through-hole of the lead wire includes the through-hole of the protective layer in the plane direction as in the example illustrated in Fig. 4.

[Example 4]

A piezoelectric element was prepared in the same manner as in Example 1 except that the center of the through-hole of the lead wire was moved to the outside of the piezoelectric film in the lateral direction by 3 mm.

That is, the piezoelectric element has a configuration in which the through-hole of the lead wire and the through-hole of the protective layer partially overlap each other in the plane direction as illustrated in Fig. 5.

[Example 5]

A piezoelectric element was prepared in the same manner as in Example 1 except that the diameter of the through-hole of the protective layer was set to 2 mm.

That is, the piezoelectric element has a configuration in which the through-hole of the lead wire includes the through-hole of the protective layer in the plane direction as in the example illustrated in Fig. 4.

[Example 6]

A piezoelectric element was prepared in the same manner as in Example 1 except that the diameter of the through-hole of the protective layer was set to 8 mm.

That is, the piezoelectric element has a configuration in which the through-hole of the protective layer includes the through-hole of the lead wire in the plane direction as in the example illustrated in Fig. 3.

[Example 7]

A piezoelectric element was prepared in the same manner as in Example 1 except that the amount of the conductive paste with which the through-hole of the protective layer was filled was reduced.

In the piezoelectric element, the through-hole of the lead wire was filled with the conductive paste up to a position approximately half of the through-hole.

[Example 8]

A piezoelectric element was prepared in the same manner as in Example 1 except that the conductive paste overflowing from the through-hole of the lead wire was not wiped off.

That is, in the piezoelectric element, the through-hole of the lead wire was filled with the conductive paste and the conductive paste was brought into contact with the main surface of the lead wire on a side opposite to the side of the protective layer, as illustrated in the example of Fig. 7.

[Example 9]

One main surface of the lead wire was roughened by sand blasting.

In a case where the surface roughness Ra of the lead wire roughened in conformity with JIS B 0601:1994 was measured, the surface roughness Ra was 1.2 $\mu$m. In addition, the surface roughness Ra of the main surface of the lead wire before roughening was measured in the same manner as described above, the surface roughness Ra was 0.2 $\mu$m.

A piezoelectric element was prepared in the same manner as in Example 1 except that the lead wire was used with the roughened surface directed to the protective layer.

[Comparative Example 1]

A piezoelectric element was prepared in the same manner as in Example 1 except that a lead wire without a through-hole was used and the amount of the conductive paste with which the through-hole of the protective layer was filled was set to an amount such that the conductive paste overflowed from the through-hole of the protective layer.

[Comparative Example 2]

A piezoelectric element was prepared in the same manner as in Comparative Example 1 except that a lead wire having one surface roughened as in Example 9 was used.

[Comparative Example 3]

A piezoelectric element was prepared in the same manner as in Example 1 except that the diameter of the through-hole of the lead wire was set to 10 mm. The filling amount of the conductive paste was the same as the amount of Example 1.

In the present example, the conductive paste was not in contact with the inner wall surface of the through-hole of the lead wire.

[Measurement of electric resistance]

The electric resistance of the connecting portion between the first electrode layer and the first lead wire of the prepared piezoelectric element was measured using an LCR meter.

In the measurement of the electric resistance, as conceptually shown in Fig. 19, a similar lead wire was mounted such that the through-holes were line-symmetric with respect to the center line of the piezoelectric film in the lateral direction, and the electric resistance between the lead wires was measured. Therefore, the distance between the centers of the through-holes to be measured was 30 mm.

Further, the electric resistance was measured immediately after the first lead wire was laminated on the first protective layer, 12 hours after the lead wire was laminated on the first protective layer, 24 hours after the lamination, and 48 hours after the lamination.

The measurement results are listed in Table 1.

[Table 1]

| | Lead wire | | Protective layer | Positional displacement of through-hole [mm] | State of conductive paste | Electric resistance with time [Ω] | | | | |
|---|---|---|---|---|---|---|---|---|---|---|
| | Diameter of through-hole [mm] | Surface roughness | Diameter of through-hole [mm] | | | Immediately after | 12 hours | 24 hours | 48 hours | 72 hours |
| Example 1 | 5 | Smooth | 5 | 0 | Though-hole is filled | OL | 3 | 1 | 1 | 1 |
| Example 2 | 2 | Smooth | 5 | 0 | Though-hole is filled | OL | 4 | 2 | 1 | 1 |
| Example 3 | 8 | Smooth | 5 | 0 | Though-hole is filled | OL | 2 | 1 | 1 | 1 |
| Example 4 | 5 | Smooth | 5 | 3 | Though-hole is filled | OL | 4 | 2 | 1 | 1 |
| Example 5 | 5 | Smooth | 2 | 0 | Though-hole is filled | OL | 3 | 1 | 1 | 1 |
| Example 6 | 5 | Smooth | 8 | 0 | Though-hole is filled | OL | 3 | 1 | 1 | 1 |
| Example 7 | 5 | Smooth | 5 | 0 | Half of through-hole | OL | 4 | 2 | 2 | 2 |
| Example 8 | 5 | Smooth | 5 | 0 | Also in contact with main surface of lead wire | OL | 3 | 0.8 | 0.8 | 0.8 |
| Example 9 | 5 | Rough | 5 | 0 | Though-hole is filled | OL | 3 | 0.5 | 0.5 | 0.5 |
| Comparative Example 1 | None | Smooth | 5 | 0 | In contact with lead wire | OL | 10 | 7 | 4 | 4 |
| Comparative Example 2 | None | Rough | 5 | 0 | In contact with lead wire | OL | 8 | 6 | 3 | 3 |
| Comparative Example 3 | 10 | Smooth | 5 | 0 | Not in contact with lead wire | OL | OL | OL | OL | OL |

EP 4 175 322 A1

23

In this table, the through-hole in the state of the conductive paste is the through-hole of the lead wire.

Over load (OL) denotes that the measurement cannot be performed due to extremely high resistance.

As listed in Table 1, according to the piezoelectric element according to the embodiment of the present invention, the electric resistance of the connecting portion between the electrode layer and the lead wire can be reduced and the drying time of the conductive paste can be reduced as compared with Comparative Example 1 and Comparative Example 2 in which a piezoelectric element of the related art having a lead wire without a through-hole was used.

Among Examples, as described in Example 1, Example 2, and Example 4, the drying time of the conductive paste can be suitably reduced by allowing the through-hole of the lead wire and the through-hole of the protective layer to coincide with each other. Among Examples, as described in Example 3, the drying time of the conductive paste can be further reduced by allowing the through-hole of the lead wire to be larger than the through-hole of the protective layer.

Further, as described in Example 1 and Example 7, the electric resistance of the connecting portion between the electrode layer and the lead wire can be further reduced by filling the through-hole of the lead wire with the conductive paste, that is, the filling member. As described in Example 8, the electric resistance of the connecting portion between the electrode layer and the lead wire can be further reduced by bringing the conductive paste, that is, the filling member into contact with the main surface of the lead wire. As described in Example 9, the electric resistance of the connecting portion between the electrode layer and the lead wire can be further reduced by setting the surface roughness of the contact surface between the lead wire and the protective layer to 0.8 $\mu$m or greater.

Further, in Comparative Example 3 in which the conductive paste, that is, the filling member was not brought into contact with the lead wire even though the lead wire had a through-hole, the electrode layer and the lead wire were not electrically connected, and the measurement could not be performed due to extremely high resistance.

As shown in the results described above, the effects of the present invention are apparent.

The present invention can be suitably used for electroacoustic transducers such as speakers, vibration sensors, and the like.

Explanation of References

10, 60: piezoelectric element
12: piezoelectric layer
14: first electrode layer
16: second electrode layer
18: first protective layer
18a, 20a, 32a, 34a: through-hole
20: second protective layer
24: matrix
26: piezoelectric particle
30: piezoelectric film
32: first lead wire
34: second lead wire
36: first filling member
36a: conductive paste
38: second filling member
50, 54: sheet-like material
52: laminate
62: vibration plate

**Claims**

1.   A piezoelectric element comprising:

a piezoelectric film including a piezoelectric layer, electrode layers which are provided on both surfaces of the piezoelectric layer, and a protective layer which is provided on a surface of the electrode layer on a side opposite to the piezoelectric layer and in which one or more through-holes are provided;
a conductive filling member with which the through-holes of the protective layer of the piezoelectric film are filled; and
a conductive member which is provided in contact with the protective layer of the piezoelectric film,

wherein the conductive member has one or more through-holes, the through-holes of the conductive member at least partially overlap the through-holes of the protective layer of the piezoelectric film in a plane direction of the piezoelectric film, and at least a part of the filling member is in contact with an inner wall surface.

2. The piezoelectric element according to claim 1,
   wherein a surface roughness Ra of a contact surface between the conductive member and the protective layer of the piezoelectric film is 0.8 $\mu$m or greater.

3. The piezoelectric element according to claim 1 or 2,
   wherein a plurality of layers of the piezoelectric film are laminated.

4. The piezoelectric element according to claim 3,
   wherein the plurality of layers of the piezoelectric film are laminated by folding the piezoelectric film one or more times.

5. The piezoelectric element according to any one of claims 1 to 4,
   wherein at least one through-hole of the conductive member is filled with the filling member.

6. The piezoelectric element according to any one of claims 1 to 5,
   wherein the filling member comes into contact with at least one main surface of the conductive member.

7. The piezoelectric element according to any one of claims 1 to 6,
   wherein at least one through-hole of the protective layer of the piezoelectric film includes at least one through-hole of the conductive member in the plane direction of the piezoelectric film.

8. The piezoelectric element according to any one of claims 1 to 7,
   wherein at least one through-hole of the conductive member includes at least one through-hole of the protective layer of the piezoelectric film in the plane direction of the piezoelectric film.

9. The piezoelectric element according to any one of claims 1 to 8,
   wherein at least one through-hole of the protective layer of the piezoelectric film coincides with at least one through-hole of the conductive member in the plane direction of the piezoelectric film.

10. The piezoelectric element according to any one of claims 1 to 9, further comprising:
    a protective member which covers the through-holes of the conductive member.

11. The piezoelectric element according to any one of claims 1 to 10,
    wherein the piezoelectric layer is a polymer-based piezoelectric composite material that contains piezoelectric particles in a matrix containing a polymer material.

# FIG. 1

# FIG. 2

# FIG. 3

# FIG. 4

# FIG. 5

## FIG. 6

## FIG. 7

# FIG. 8

18a     36     32a

32

18

14

12

# FIG. 9

42

18a    36     32a

32

18

14

12

# FIG. 10

# FIG. 11

# FIG. 12

## FIG. 13

## FIG. 14

## FIG. 15

## FIG. 16

## FIG. 17

# FIG. 18

FIG. 19

## INTERNATIONAL SEARCH REPORT

| International application No. |
| --- |
| PCT/JP2021/019822 |

**A. CLASSIFICATION OF SUBJECT MATTER**
H04R 17/00(2006.01)i; H01L 41/047(2006.01)i; H01L 41/09(2006.01)i; H01L 41/193(2006.01)i
FI: H01L41/047; H04R17/00; H01L41/09; H01L41/193
According to International Patent Classification (IPC) or to both national classification and IPC

**B. FIELDS SEARCHED**

Minimum documentation searched (classification system followed by classification symbols)
H04R17/00; H01L41/047; H01L41/09; H01L41/193

Documentation searched other than minimum documentation to the extent that such documents are included in the fields searched
| | |
| --- | --- |
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y<br>A | JP 2014-209724 A (FUJIFILM CORPORATION) 06 November 2014 (2014-11-06) paragraphs [0028], [0035], [0132], [0133], fig. 1-18 | 1, 9, 11<br>3-6<br>2, 7, 8, 10 |
| Y | WO 2020/095812 A1 (FUJIFILM CORPORATION) 14 May 2020 (2020-05-14) paragraph [0082], fig. 1-18 | 3-6 |
| Y | JP 2016-15354 A (FUJIFILM CORPORATION) 28 January 2016 (2016-01-28) paragraphs [0080]-[0085], fig. 1, 2 | 5, 6 |
| A | JP 2017-45984 A (ROHM CO., LTD.) 02 March 2017 (2017-03-02) paragraphs [0025], [0026], fig. 1-40 | 1-11 |

☐ Further documents are listed in the continuation of Box C.  ☒ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| 11 August 2021 (11.08.2021) | 24 August 2021 (24.08.2021) |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
| --- | --- |

Form PCT/ISA/210 (second sheet) (January 2015)

INTERNATIONAL SEARCH REPORT
Information on patent family members

International application No.

PCT/JP2021/019822

| Patent Documents referred in the Report | Publication Date | Patent Family | Publication Date |
|---|---|---|---|
| JP 2014-209724 A | 06 Nov. 2014 | US 2016/0014527 A1 paragraphs [0081], [0095], [0316]-[0322], fig. 1-18 WO 2014/157006 A1 | |
| WO 2020/095812 A1 | 14 May 2020 | (Family: none) | |
| JP 2016-15354 A | 28 Jan. 2016 | (Family: none) | |
| JP 2017-45984 A | 02 Mar. 2017 | US 2017/0062696 A1 paragraphs [0138]-[0140], fig. 1-40 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015029270 A

- JP 2015109627 A